# EUROPEAN PATENT APPLICATION

(11) **EP 4 672 937 A1**
(43) Date of publication of application: **31.12.2025**
(21) Application number: 24777556.2
(22) Date of filing: 19.02.2024
(51) Int. Cl.: H10K 59/126, H10K 71/00, H10K 50/844

(54) **DISPLAY SUBSTRATE AND PREPARATION METHOD THEREFOR, AND DISPLAY DEVICE**

(30) Priority: 31.03.2023 CN 202310341484
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: ZHANG, Jingli, Daxing District Beijing 100176 (CN); SONG, Erlong, Daxing District Beijing 100176 (CN); ZHANG, Kai, Daxing District Beijing 100176 (CN); CHU, Xiaodong, Daxing District Beijing 100176 (CN)
(74) Representative: Durán-Corretjer, S.L.P.
(86) International application number: PCT/CN2024/077544
(87) International publication number: WO 2024/198763

(57) **Abstract**

A display substrate and a preparation method therefor, and a display device. The display substrate comprises a hole area, a transition area surrounding the hole area, and a display area surrounding the transition area, wherein the transition area is provided with isolation columns surrounding the hole area, each isolation column comprising a first isolation portion and a first coating layer. The display substrate comprises a base. The first isolation portion comprises a second electrically conductive layer, and a first side and a second side of the first isolation portion respectively face the display area and the hole area. The first coating layer is arranged on the side of the first isolation portion away from the base, and coats one of the first side and the second side of the first isolation portion. On the other one of the first side and the second side of the first isolation portion, the second electrically conductive layer retracts relative to the first coating layer, which is made of an insulating material.

## Description

The present application claims priority to Chinese Patent Application No. 202310341484.5 filed to the CNIPA on March 31, 2023 and entitled "Display Substrate and Preparation Method Therefor, and Display Device", contents of which should be construed as being incorporated into the present application by reference.

### Technical Field

The present disclosure relates to, but is not limited to, the field of display technologies, and in particular to a display substrate and a manufacturing method therefor, and a display apparatus.

### Background

With the development of display technology, people have higher and higher requirements for the performance of display products. Only displays that can withstand a series of tests such as long-term high temperature and high humidity testing and pressure testing can meet the demand and be qualified and good products.

Organic light emitting diode (OLED) display products have gradually become the mainstream products in the display field because of their advantages such as self-luminescence, wide viewing angle, high contrast, low power consumption and extremely high response speed. However, reliability has always been the test of OLED display products. The high-temperature and high-humidity operation test is to place the display screen in a high-temperature and high-humidity environment when it is powered on. After 672 hours, the display screen is observed to see if there is poor reliability. For OLED display products designed with openings, because a bezel of a hole region is very narrow, the reliability near the hole region is weak. In order to prevent external water vapor and oxygen from invading the display region from the hole region through a light emitting functional layer and a cathode layer (an OLED light emitting element includes an anode, a light emitting functional layer and a cathode layer stacked in sequence), in some technologies, isolation posts are provided in the bezel of the hole region to partition the light emitting functional layer and the cathode layer to block an intrusion channel of water and oxygen. However, when the display screen is powered on, the conductive ions in the conductive adhesive or the polarizer of the display screen will be free to the display region under the action of electric field, resulting in product reliability failure.

### Summary

The following is a summary of subject matters described herein in detail. This summary is not intended to limit the protection scope of claims.

An embodiments of the present disclosure provides a display substrate including a hole region, a transition region around the hole region, and a display region around the transition region. The transition region is provided with an isolation post around the hole region, and the isolation post includes a first isolation portion and a first covering layer. The display substrate includes a base substrate, the first isolation portion includes a second conductive layer, a first side of the first isolation portion faces the display region, and a second side of the first isolation portion faces the hole region. The first covering layer is disposed on a side of the first isolation portion away from the base substrate, and covers one of the first side and the second side of the first isolation portion, and on the other of the first side and the second side of the first isolation portion, the second conductive layer shrinks inward relative to the first covering layer. A material of the first covering layer is an insulation material.

An embodiment of the present disclosure further provides a display apparatus including the display substrate described above.

An embodiment of the present disclosure further provides a manufacturing method for the display substrate, including:
forming a first isolation layer on the base substrate of the transition region, wherein the first isolation layer includes a first film layer, a second film layer, and a third film layer sequentially stacked along a direction away from the base substrate, and edges of the first film layer, the second film layer, and the third film layer are flush on a side of the first isolation layer facing the display region and a side of the first isolation layer facing the hole region;
completely removing the third film layer by an etching process;
forming a first covering layer on a surface of the second film layer away from the base substrate, wherein the first covering layer covers the side of the first isolation layer facing the display region or the hole region, and on a side of the first isolation layer that is not covered by the first covering layer, edges of the second film layer and the first film layer protrude from an edge of the first covering layer;
etching the first isolation layer by the etching process so that on the side of the first isolation layer that is not covered by the first covering layer, the edge of the second film layer is flush with the edge of the first covering layer, and the edge of the first film layer protrudes from the edge of the second film layer or is flush with the edge of the second film layer; and
etching the second film layer by the etching process so that on the side of the first isolation layer that is not covered by the first covering layer, the edge of the second film layer shrinks inward relative to the edge of the first covering layer and the edge of the first film layer, thereby making the first film layer and the second film layer of the first isolation layer become the first conductive layer and the second conductive layer of the first isolation portion, respectively.

Other aspects of the present disclosure may be comprehended after the drawings and the detailed description are read and understood.

### Brief Description of Drawings

Accompanying drawings are intended to provide further understanding of technical solutions of the present disclosure and form a part of the specification, and are used to explain the technical solutions of the present disclosure together with embodiments of the present disclosure, but do not form limitations on the technical solutions of the present disclosure. Shapes and sizes of components in the drawings do not reflect actual scales, and are only intended to schematically illustrate contents of the present disclosure.
FIG. 1 is a schematic diagram of a planar structure of a display substrate in some exemplary embodiments.
FIG. 2 is a schematic diagram of a cross-sectional structure taken along A-A in FIG. 1 in some exemplary embodiments.
FIG. 3 is a schematic diagram of a structure of an isolation post partitioning a light emitting functional layer in some techniques.
FIG. 4 is a schematic diagram of a structure of an isolation post partitioning a light emitting functional layer according to some other techniques.
FIG. 5 is a schematic diagram of a structure in which a third metal conductive layer of the isolation post in FIG. 4 is upturned and laps with the light emitting functional layer.
FIG. 6 is a schematic diagram of a structure in which the light emitting functional layer in FIG. 4 is bent downward and laps with the third metal conductive layer of the isolation post.
FIG. 7a is a schematic diagram of a cross-sectional structure of an isolation post of a display substrate according to some exemplary embodiments.
FIG. 7b is a schematic diagram of a cross-sectional structure of an isolation post of a display substrate according to some other exemplary embodiments.
FIG. 7c is a schematic diagram of a cross-sectional structure of an isolation post of a display substrate according to some other exemplary embodiments.
FIG. 8 is a schematic diagram of a cross-sectional structure of an isolation post of a display substrate according to some other exemplary embodiments.
FIG. 9 is a schematic diagram of a cross-sectional structure of an isolation post of a display substrate according to still some exemplary embodiments.
FIG. 10 is a schematic diagram of a cross-sectional structure of an isolation post of a display substrate according to still some exemplary embodiments.
FIG. 11 is a schematic diagram of a cross-sectional structure of an isolation post of a display substrate according to still some exemplary embodiments.
FIG. 12a is a schematic diagram of a display substrate after a fourth insulation layer is formed according to some exemplary embodiments.
FIG. 12b is a schematic diagram of a structure of a display substrate after a first source-drain metal layer is formed according to some exemplary embodiments.
FIG. 12c is a schematic diagram of a structure of a display substrate after a third metal layer of a first isolation layer is removed according to some exemplary embodiments.
FIG. 12d is a schematic diagram of a structure of a display substrate after a passivation layer is formed according to some exemplary embodiments.
FIG. 12e is a schematic diagram of a structure of a display substrate after a second source-drain metal layer is formed according to some exemplary embodiments.
FIG. 12f is a schematic diagram of a structure of a display substrate after a pixel definition layer is formed according to some exemplary embodiments.
FIG. 12g is a schematic diagram of a structure of a display substrate after a second metal layer of a first isolation layer is etched according to some exemplary embodiments.
FIG. 13a is a schematic diagram of a structure of a display substrate after a second source-drain metal layer is formed according to some other exemplary embodiments.
FIG. 13b is a schematic diagram of a structure of a display substrate after a sixth metal layer of a first isolation layer is removed according to some other exemplary embodiments.
FIG. 13c is a schematic diagram of a structure of a display substrate after a second planarization layer is formed according to some other exemplary embodiments.
FIG. 13d is a schematic diagram of a structure of a display substrate after a first electrode is formed according to some other exemplary embodiments.
FIG. 13e is a schematic diagram of a structure of a display substrate after a pixel definition layer is formed according to some other exemplary embodiments.
FIG. 13f is a schematic diagram of a structure of a display substrate after a fifth metal layer of a first isolation layer is etched according to some other exemplary embodiments.
FIG. 14a is a schematic diagram of a structure of a display substrate after a fourth insulation layer is formed according to still some exemplary embodiments.
FIG. 14b is a schematic diagram of a structure of a display substrate after a first source-drain metal layer is formed according to still some exemplary embodiments.
FIG. 14c is a schematic diagram of a structure of a display substrate after a portion of a third metal layer of a first isolation layer is etched according to still some exemplary embodiments.
FIG. 14d is a schematic diagram of a structure of a display substrate after a passivation layer is formed according to still some exemplary embodiments.
FIG. 14e is a schematic diagram of a structure of a display substrate after a second source-drain metal layer is formed according to still some exemplary embodiments.
FIG. 14f is a schematic diagram of a structure of a display substrate after a pixel definition layer is formed according to still some exemplary embodiments.
FIG. 14g is a schematic diagram of a structure of a display substrate after a second metal layer of a first isolation layer is etched according to still some exemplary embodiments.
FIG. 15a is a schematic diagram of a structure of a display substrate after a fourth insulation layer is formed according to still some exemplary embodiments.
FIG. 15b is a schematic diagram of a structure of a display substrate after a first source-drain metal layer is formed according to still some exemplary embodiments.
FIG. 15c is a schematic diagram of a structure of a display substrate after a passivation layer is formed according to still some exemplary embodiments.
FIG. 15d is a schematic diagram of a structure of a display substrate after a second source-drain metal layer is formed according to still some exemplary embodiments.
FIG. 15e is a schematic diagram of a structure of a display substrate after a portion of a third metal layer of a first isolation layer is etched according to still some exemplary embodiments.
FIG. 15f is a schematic diagram of a structure of a display substrate after a second metal layer of a first isolation layer is etched according to still some exemplary embodiments.

### Detailed Description

Those of ordinary skills in the art should understand that modifications or equivalent replacements may be made to the technical solutions of the embodiments of the present disclosure without departing from the spirit and scope of the technical solutions of the embodiments of the present disclosure, and should all fall within the scope of the claims of the present disclosure.

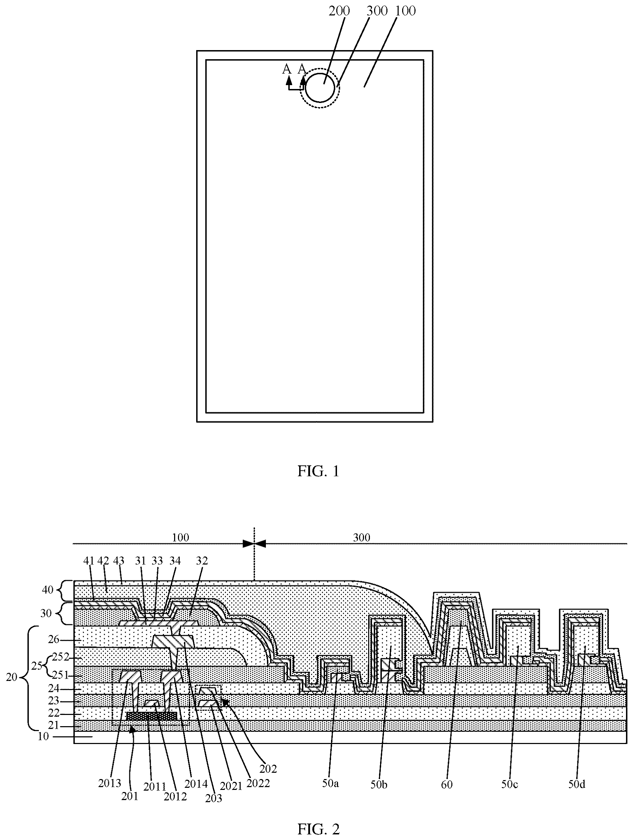

As shown in FIGS. 1 and 2, FIG. 1 is a schematic planar diagram of a structure of a display substrate according to some exemplary embodiments, and FIG. 2 is a schematic diagram of a cross-sectional structure taken along line A-A in FIG. 1 according to some exemplary embodiments. The display substrate includes a hole region 200, a transition region 300 around the hole region 200, and a display region 100 around the transition region 300.

For example, the display region 100 includes a drive structure layer 20, a light emitting structure layer 30, and an encapsulation structure layer 40 sequentially stacked on a base substrate 10.

The drive structure layer 20 includes a plurality of pixel drive circuits, and a pixel drive circuit includes a plurality of transistors (T) 201 and a storage capacitor (C) 202. The pixel drive circuit may adopt a structure such as 3T1C, 4T1C, 5T1C, 5T2C, 6T1C, or 7T1C, and the present disclosure is not limited thereto.

The light emitting structure layer 30 includes a plurality of light emitting elements, and the light emitting elements may be OLED (Organic Light Emitting Diode) or QLED (Quantum Dot Light Emitting Diode) devices. In a direction perpendicular to the base substrate 10, the light emitting structure layer 30 includes a first electrode layer, a pixel definition layer 32, a light emitting functional layer, and a second electrode layer 34 disposed in sequence. The first electrode layer includes a plurality of first electrodes 31, the pixel definition layer 32 is disposed on a side of the plurality of first electrodes 31 away from the base substrate 10 and is provided with a plurality of pixel openings, the pixel openings expose the first electrodes 31, and the light emitting functional layer and the second electrode layer 34 are sequentially stacked on a side of the first electrodes 31 away from the base substrate 10. The light emitting element includes a first electrode 31, a light emitting functional layer 33, and a second electrode layer 34. The light emitting functional layer 33 includes an organic light emitting layer, and may further include any one or more film layers of a hole injection layer, a hole transporting layer, and an electron blocking layer located between the first electrode 31 and the organic light emitting layer, and any one or more film layers of an electron injection layer, an electron transporting layer, and a hole blocking layer located between the second electrode layer 34 and the organic light emitting layer. The first electrode 31 of the light emitting element is connected to the pixel drive circuit, and the light emitting element emits light when driven by the pixel drive circuit.

The encapsulation structure layer 40 may include a first encapsulation layer 41, a second encapsulation layer 42, and a third encapsulation layer 43 that are stacked sequentially along a direction away from the base substrate 10. The main material of the first encapsulation layer 41 and the third encapsulation layer 43 (the material of the largest component in the film layer) is an inorganic material, and may include at least one of silicon oxide, silicon nitride, and silicon oxynitride, and the main material of the second encapsulation layer 42 may be an organic material, such as epoxy resin, so as to facilitate encapsulation and avoid erosion of water vapor. The first encapsulation layer 41 and the third encapsulation layer 43 may be formed using a chemical vapor deposition (CVD) process, and the second encapsulation layer 42 may be formed using an ink jet printing (IJP) process.

For example, the transition region 300 is provided with an isolation dam 60 and an isolation post 50, both of which are disposed around the hole region 200. A surface of the isolation dam 60 away from the base substrate 10 is higher than a surface of the isolation post 50 away from the base substrate 10. The number of isolation dams 60 and isolation posts 50 may be not limited. In the process of forming the second encapsulation layer 42 of the encapsulation structure layer 40 by the ink jet printing process, the ink jet printing material may overflow, and the isolation dam 60 may function in preventing the ink jet printing material from overflow. The isolation post 50 may function in partitioning the light emitting functional layer 33 and the second electrode layer 34 to prevent water and oxygen from eroding from the hole region 200 along the light emitting functional layer 33 and the second electrode layer 34 to the display region 100, and protect the light emitting functional layer 33 and the second electrode layer 34 of the display region 100 from being eroded by water and oxygen.

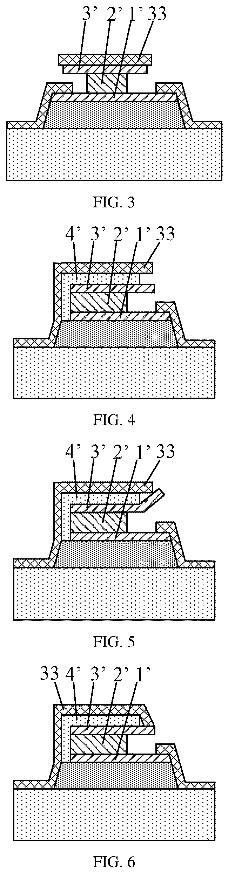

In some technologies, as shown in FIG. 3, which is a schematic diagram of a structure of an isolation post partitioning a light emitting functional layer in some technologies, the isolation post includes a first metal conductive layer 1', a second metal conductive layer 2' and a third metal conductive layer 3' stacked sequentially along a direction away from the base substrate. In a cross section of the isolation post perpendicular to the base substrate, the first metal conductive layer 1', the second metal conductive layer 2' and the third metal conductive layer 3' are generally in an shape of a Chinese character "I". After the light emitting functional layer 33 is partitioned by the isolation post, the light emitting functional layers 33 located on both side of the isolation post (one side facing the display region 100 and the other side facing the hole region 200) are lapped on the first metal conductive layer 1', and are connected by the first metal conductive layer 1' to form an conductive pathway. In this way, after the hole region is formed, the conductive adhesive or polarizer of the display screen is adhered to the light emitting functional layer 33 at the edge of the hole region. Thus, when the display screen is powered on, the conductive ions in the conductive adhesive or polarizer are free to the display region through the conductive pathway under the action of the electric field, resulting in product reliability failure. In order to solve this problem, the structure of the isolation post is optimized. As shown in FIG. 4, one side of the isolation post is covered with an insulation layer 4' to block the conductive pathway. After the insulation layer 4' covers one side (first side) of the isolation post, the insulation layer 4' is partially located on a surface of the third metal conductive layer 3' away from the base substrate, and a portion of the third metal conductive layer 3' close to the other side (second side) of the isolation post is not covered by the insulation layer 4'. After the light emitting functional layer 33 is disconnected on a side of the isolation post which is not covered by the insulation layer 4', the light emitting functional layer 33 located on the first side of the isolation post is partially located on the insulation layer 4' on a surface of the third metal conductive layer 3' away from the base substrate, and the light emitting functional layer 33 located on the second side of the isolation post is partially located on the first metal conductive layer 1'. In practical application, it is found that, as shown in FIG. 5, a portion of the third metal conductive layer 3' close to the second side of the isolation post that is not covered by the insulation layer 4' is upturned and may lap with the light emitting functional layer 33 on the insulation layer 4' located on a surface of the third metal conductive layer 3' away from the base substrate. Alternatively, as shown in FIG. 6, the light emitting functional layer 33 on the insulation layer 4' located on a surface of the third metal conductive layer 3' away from the base substrate will bend downward and may lap with a portion of the third metal conductive layer 3' close to the second side of the isolation post that is not covered by the insulation layer 4', so that the light emitting functional layer 33 located on the first side of the isolation post is still connected with the light emitting functional layer 33 located on the second side of the isolation post through the third metal conductive layer 3', the second metal conductive layer 2' and the first metal conductive layer 1' to form a conductive pathway. In this way, when the display screen is powered on, the conductive ions in the conductive adhesive or the polarizer will still free to the display region through the conductive pathway under the action of the electric field, resulting in product reliability failure.

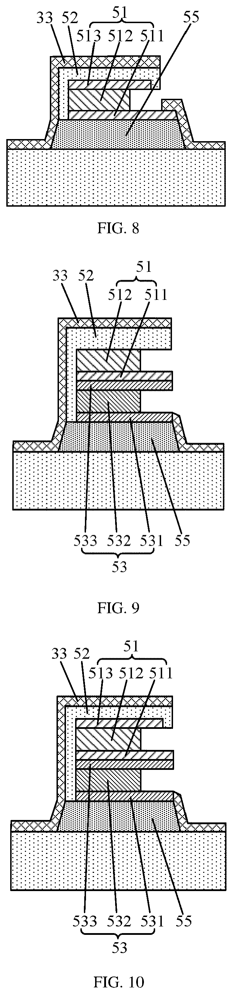

As shown in FIGS. 1, 2, 7a, and 8, FIG. 7a is a schematic diagram of a cross-sectional structure of an isolation post of a display substrate according to some exemplary embodiments, and FIG. 8 is a schematic diagram of a cross-sectional structure of an isolation post of a display substrate according to some other exemplary embodiments. An embodiment of the present disclosure provides a display substrate including a hole region 200, a transition region 300 around the hole region 200, and a display region 100 around the transition region 300. The transition region 300 is provided with an isolation post 50 around the hole region 200, and the isolation post 50 includes a first isolation portion 51 and a first covering layer 52. The display substrate includes a base substrate 10, the first isolation portion 51 includes a second conductive layer 512, a first side of the first isolation portion 51 faces the display region 100, and a second side of the first isolation portion 51 faces the hole region 200. The first covering layer 52 is disposed on a side of the first isolation portion 51 away from the base substrate 10, and covers one of the first side and the second side of the first isolation portion 51, and the second conductive layer 512 shrinks inward relative to the first covering layer 52 on the other of the first side and the second side of the first isolation portion 51. The material of the first covering layer 52 is an insulation material.

In the display substrate of the embodiment of the present disclosure, by providing the first covering layer 52 made of an insulation material and covering one of the first side and the second side of the first isolation portion 51, and shrinking the second conductive layer 512 inward relative to the first covering layer 52 (that is, the first covering layer 52 protrudes relative to the second conductive layer 512) on the other of the first side and the second side of the first isolation portion 51, the light emitting functional layer 33 of the display substrate can be disconnected at one of the first side and the second side of the first isolation portion 51 that is not covered by the first covering layer 52. When the light emitting functional layer 33 is disconnected at the isolation post 50, the light emitting functional layer 33 located on the first covering layer 52 will not lap with the second conductive layer 512. In this way, the light emitting functional layer 33 located on a side of the isolation post 50 facing the display region 100 will not be connected with the light emitting functional layer 33 located on a side of the isolation post 50 facing the hole region 200 through the first isolation portion 51 with conductive function to form the conductive pathway. Therefore, it is avoided that the conductive ions in the conductive adhesive or the polarizer of the display screen are free to the display region 100 through the conductive pathway under the action of an electric field when the display screen is powered on in some techniques, resulting in the problem of product reliability failure.

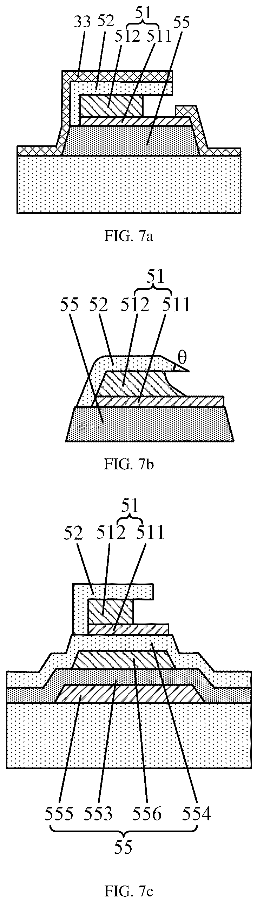

In some exemplary embodiments, as shown in FIG. 7a, the first isolation portion 51 further includes a first conductive layer 511 disposed on a side of the second conductive layer 512 close to the base substrate 10. The first covering layer 52 is disposed on a surface of the second conductive layer 512 away from the base substrate 10 and covers one of the first side and the second side of the first isolation portion 51, and the second conductive layer 512 also shrinks inward relative to the first conductive layer 511 on the other of the first side and the second side of the first isolation portion 51. In the present embodiment, the first isolation portion 51 may include only the first conductive layer 511 and the second conductive layer 512.

In some examples of the present embodiment, the second conductive layer 512 may shrink inward by approximately 0.35 microns to 0.4 microns relative to the first covering layer 52, which helps the isolation post 50 to partition the light emitting functional layer 33. Furthermore, when the light emitting functional layer 33 is disconnected at the isolation post 50, the light emitting functional layer 33 located on the first covering layer 52 will not lap with the second conductive layer 512 on the other of the first side and the second side of the first isolation 51.

In some examples of the present embodiment, as shown in FIG. 7b, which is a schematic diagram of a cross-sectional structure of an isolation post of a display substrate according to some other exemplary embodiments, on the other of the first side and the second side of the first isolation portion 51 (the side not covered by the first covering layer 52), a portion of the first covering layer 52 close to an edge thereof is smaller in thickness than the remaining portion of the first covering layer 52. The portion of the first covering layer 52 close to an edge thereof may have a slope angle θ of about 20 degrees to 45 degrees.

In some exemplary embodiments, as shown in FIG. 8, the first isolation portion 51 may further include a third conductive layer 513 disposed on a side of the second conductive layer 512 away from the base substrate 10, and the first covering layer 52 is disposed on a surface of the third conductive layer 513 away from the base substrate 10 and covers one of the first side and the second side of the first isolation portion 51. On the other of the first side and the second side of the first isolation portion 51, the second conductive layer 512 also shrinks inward relative to the third conductive layer 513.

In some examples of the present embodiment, as shown in FIG. 8, the first covering layer 52 also covers a surface of the third conductive layer 513 located on the other of the first side and the second side of the first isolation portion 51 (the side not covered by the first covering layer 52). An orthographic projection of the third conductive layer 513 on the base substrate 10 falls within an orthographic projection of the first covering layer 52 on the base substrate 10.

In this embodiment, since the first covering layer 52 also covers the surface of the third conductive layer 513 located on the other of the first side and the second side of the first isolation part 51, when the light emitting functional layer 33 is disconnected at the isolation post 50, the light emitting functional layer 33 located on the first covering layer 52 will not lap with the third conductive layer 513 located on the other of the first side and the second side of the first isolation part 51. In this way, the light emitting functional layer 33 located on a side of the isolation post 50 facing the display region 100 and the light emitting functional layer 33 located on a side of the isolation post 50 facing the hole region 200 will not be connected by the first isolation portion 51 with conductive function to form a conductive pathway. Therefore, it is avoided that the conductive ions in the conductive adhesive or the polarizer of the display screen are free to the display region 100 through the conductive pathway under the action of an electric field when the display screen is powered on in some techniques, resulting in the problem of product reliability failure.

In some examples of the present embodiment, the second conductive layer 512 may shrink inward by approximately 0.35 microns to 0.4 microns relative to the first covering layer 52.

In some examples of the present embodiment, on the other of the first side and the second side of the first isolation portion 51, a portion of the first covering layer 52 close to an edge thereof may have a slope of about 50 degrees to 75 degrees, and reference may be made to the slope angle θ in FIG. 7b.

In some exemplary embodiments, as shown in FIG. 9, which is a schematic diagram of a cross-sectional structure of an isolation post of a display substrate according to still some exemplary embodiments, the isolation post may further include a second isolation portion 53 disposed on a side of the first isolation portion 51 facing the base substrate 10. The second isolation portion 53 includes a fourth conductive layer 531, a fifth conductive layer 532, and a sixth conductive layer 533 sequentially stacked along a direction away from the base substrate 10. A first side of the second isolation portion 53 faces the display region 100, and a second side of the second isolation portion 53 faces the hole region 200. The first covering layer 52 also covers one of the first side and the second side of the second isolation portion 53, and the fifth conductive layer 532 shrinks inward relative to the fourth conductive layer 531 and the sixth conductive layer 533 on the other of the first side and the second side of the second isolation portion 53. In other embodiments, the second isolation portion 53 may include only the fourth conductive layer 531 and the fifth conductive layer 532 sequentially stacked along a direction away from the base substrate 10, and the sixth conductive layer 533 may not be provided.

In the present embodiment, by providing the second isolation portion 53, the light emitting functional layer 33 can be disconnected on the side of the first side and the second side of the second isolation portion 53 that is not covered by the first covering layer 52, and the partition effect of the isolation post on the light emitting functional layer 33 can be improved.

In some examples of the present embodiment, as shown in FIG. 9, the side of the first side and the second side of the first isolation portion 51 covered by the first covering layer 52 and the side of the first side and the second side of the second isolation portion 53 covered by the first covering layer 52 are located on the same side of the isolation post. For example, the side of the first side and the second side of the first isolation portion 51 covered by the first covering layer 52 and the side of the first side and the second side of the second isolation portion 53 covered by the first covering layer 52 may both be located on a side of the isolation post facing the display region 100, or may both be located on a side of the isolation post facing the hole region 200.

In some examples of the present embodiment, as shown in FIG. 9, the first conductive layer 511 may be disposed on a surface of the sixth conductive layer 533 away from the base substrate 10. The materials of the first conductive layer 511 and the sixth conductive layer 533 may be the same or different.

In some exemplary embodiments, as shown in FIGS. 9 and 10, FIG. 10 is a schematic diagram of a cross-sectional structure of an isolation post of a display substrate according to still some exemplary embodiments, and the isolation post includes a first isolation portion 51, a first covering layer 52, and a second isolation portion 53. In the example of FIG. 9, the structure of the first isolation portion 51 may be the same as that of the first isolation portion 51 of FIG. 7a, in which the first isolation portion 51 includes a first conductive layer 511 and a second conductive layer 512 stacked sequentially along a direction away from the base substrate 10. The first covering layer 52 is disposed on a surface of the second conductive layer 512 away from the base substrate 10, and covers a side of the first isolation portion 51 and the second isolation portion 53 facing the display region 100 or the hole region 200. On a side of the first isolation portion 51 that is not covered by the first covering layer 52, the second conductive layer 512 shrinks inward relative to the first conductive layer 512 and the first covering layer 52 . In the example of FIG. 10, the structure of the first isolation portion 51 may be the same as that of FIG. 8, the first isolation portion 51 includes a first conductive layer 511, a second conductive layer 512, and a third conductive layer 513 sequentially stacked along a direction away from the base substrate 10. The first covering layer 52 is disposed on a surface of the third conductive layer 513 away from the base substrate 10, and covers a side of the first isolation portion 51 and the second isolation portion 53 facing the display region 100 or the hole region 200, and covers a surface of the third conductive layer 513 located on a side of the first isolation portion 51 that is not covered by the first covering layer 52. On a side of the first isolation portion 51 that is not covered by the first covering layer 52, the second conductive layer 512 shrinks inward relative to the first conductive layer 511 and the third conductive layer 513.

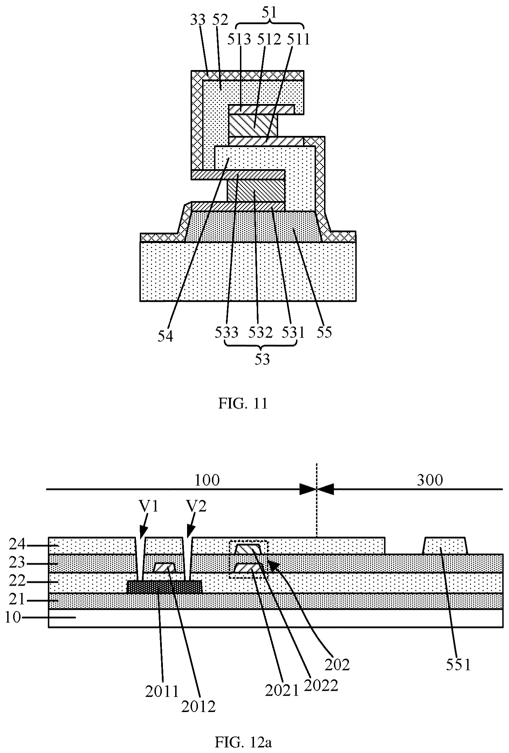

In some exemplary embodiments, as shown in FIG. 11, which is a schematic diagram of a cross-sectional structure of an isolation post of a display substrate according to still some exemplary embodiments, the isolation post 50 includes a first isolation portion 51 and a first covering layer 52. The first isolation portion 51 includes a first conductive layer 511 and a second conductive layer 512 sequentially stacked along a direction away from the base substrate 10, a first side of the first isolation portion 51 faces the display region 100, and a second side of the first isolation portion 51 faces the hole region 200. The first covering layer 52 is disposed on a side of the first isolation portion 51 away from the base substrate 10, and covers one of the first side and the second side of the first isolation portion 51, and on the other of the first side and the second side of the first isolation portion 51, the second conductive layer 512 shrinks inward relative to the first conductive layer 511 and the first covering layer 52. The material of the first covering layer 52 is an insulation material.

The isolation post 50 may further include a second isolation portion 53 and a second covering layer 54. The second isolation portion 53 is disposed a side of the first isolation portion 51 facing the base substrate 10, a first side of the second isolation portion 53 faces the display region 100, and a second side of the second isolation portion 53 faces the hole region 200. The second covering layer 54 is disposed between the second isolation portion 53 and the first isolation portion 51, and covers one of the first side and the second side of the second isolation portion 53. The material of the second isolation portion 53 is a conductive material, and the material of the second covering layer 54 is an insulation material.

In some examples of the present embodiment, as shown in FIG. 11, the second isolation portion 53 may include a fourth conductive layer 531, a fifth conductive layer 532, and a sixth conductive layer 533 sequentially stacked along a direction away from the base substrate 10. On the other of the first side and the second side of the second isolation portion 53 (the side not covered by the second covering layer 54), the fifth conductive layer 532 shrinks inward relative to the fourth conductive layer 531 and the sixth conductive layer 533.

In some examples of the present embodiment, as shown in FIG. 11, the side of the first side and the second side of the first isolation portion 51 covered by the first covering layer 52 and the side of the first side and the second side of the second isolation portion 53 covered by the second covering layer 54 may be located on different sides of the isolation post 50. For example, the side of the first side and the second side of the first isolation portion 51 covered by the first covering layer 52 is located on the side of the isolation post 50 facing the display region 100, and the side of the first side and the second side of the second isolation portion 53 covered by the second covering layer 54 is located on the side of the isolation post 50 facing the hole region 200. Alternatively, the side of the first side and the second side of the first isolation portion 51 covered by the first covering layer 52 is located on the side of the isolation post 50 facing the hole region 200, and the side of the first side and the second side of the second isolation portion 53 covered by the second covering layer 54 is located on the side of the isolation post 50 facing the display region 100. In other implementations, the side of the first side and the second side of the first isolation portion 51 covered by the first covering layer 52 and the side of the first side and the second side of the second isolation portion 53 covered by the second covering layer 54 may be located on the same side of the isolation post 50. For example, the side of the first side and the second side of the first isolation portion 51 covered by the first covering layer 52 and the side of the first side and the second side of the second isolation portion 53 covered by the second covering layer 54 may both be located on a side of the isolation post 50 facing the display region 100, or may both be located on a side of the isolation post 50 facing the hole region 200.

In some exemplary embodiments, the number of isolation portions of the isolation post may be one or more. For example, in the examples of FIGS. 7a and 8, the isolation portion may be only one in number (i.e., the first isolation portion), in the examples of FIGS. 9, 10 and 11, the isolation portions may be two in number (i.e., the first isolation portion and the second isolation portion), and in other implementations, the number of isolation portions may be three or four, etc. The number of the isolation portions of the isolation post is not limited in the embodiments of the present disclosure.

In some exemplary embodiments, as shown in FIGS. 7a and 8, the isolation post 50 may further include a post base 55 disposed on a side of the first isolation portion 51 facing the base substrate 10, and the post base 55 may include one or more film layers.

In some examples of the present embodiment, the post base 55 may include one inorganic insulation layer or a plurality of inorganic insulation layers stacked. Alternatively, the post base 55 may include at least one inorganic insulation layer and at least one metal layer, and the metal layer may be covered by the inorganic insulation layer.

For example, as shown in FIG. 7c, which is a schematic diagram of a cross-sectional structure of an isolation post of a display substrate according to some other exemplary embodiments, the post base 55 may include a seventh metal layer 555, a first inorganic insulation layer 553, an eighth metal layer 556, and a second inorganic insulation layer 554, which are sequentially stacked along a direction away from the base substrate. The first inorganic insulation layer 553 covers the seventh metal layer 555, and the second inorganic insulation layer 554 covers the eighth metal layer 556. The first isolation portion 51 may be disposed on a surface of the second inorganic insulation layer 554 away from the base substrate.

In some examples of the present embodiment, as shown in FIGS. 7a and 8, when the isolation post 50 does not include the second isolation portion 53, the first conductive layer 511 of the first isolation portion 51 may be disposed on a surface of the post base 55 away from the base substrate 10.

In some examples of the present embodiment, as shown in FIGS. 9 and 10, when the isolation post 50 includes the second isolation portion 53, the post base 55 may be disposed on a side of the second isolation portion 53 facing the base substrate 10, and the fourth conductive layer 531 of the second isolation portion 53 may be disposed on a surface of the post base 55 away from the base substrate 10.

In some exemplary embodiments, as shown in FIG. 2, the display region 100 includes a drive structure layer 20 and a light emitting structure layer 30 sequentially stacked on the base substrate 10. The drive structure layer 20 includes a pixel drive circuit including a plurality of transistors 201 and a storage capacitor 202. The light emitting structure layer 30 includes a plurality of light emitting elements, and the light emitting element includes a first electrode 31, a light emitting functional layer 33, and a second electrode layer 34 sequentially stacked along a direction away from the base substrate 10.

In a direction perpendicular to the base substrate 10, the drive structure layer 20 may include a first source-drain metal layer, a fifth insulation layer 25, a second source-drain metal layer, and a second planarization layer 26, which are sequentially disposed along a direction away from the base substrate 10. The first source-drain metal layer includes a source electrode 2013 and a drain electrode 2014 of at least one of the transistors 201, and the second source-drain metal layer includes a connection electrode 203 connected to the source electrode 2013 or the drain electrode 2014 of the transistor 201, and the connection electrode 203 is also connected to the first electrode 31.

In some examples of the present embodiment, the first source-drain metal layer may include a plurality of metal layers that are stacked, and the first isolation portion 51 and the source electrode 2013 and the drain electrode 2014 of the transistor 201 are disposed in a same layer. The film layers of the first isolation portion 51 and the film layers of the source electrode 2013 and the drain electrode 2014 of the transistor 201 may be the same. Alternatively, the number of the film layers of the first isolation portion 51 may be less than the number of the film layers of the source electrode 2013 and the drain electrode 2014 of the transistor 201.

Herein, "A and B are disposed in a same layer" means that the film layers of A and the film layers of B are derived from the same thin film, which may be a single-layer structure or a multi-layer composite structure, and the film layers of A and the film layers of B may be the same or different. "A and B are disposed in a same layer" can be understood as meaning that the same thin film is subjected to the same patterning process to form A and B at the same time, or that the same thin film is subjected to the same patterning process to form A' and B' at the same time, A' is subjected to further processing (such as etching, etc.) to obtain A, and B' is subjected to further processing (such as etching, etc.) to obtain B.

For example, the first source-drain metal layer may include a first metal layer 301, a second metal layer 302, and a third metal layer 303 sequentially stacked along a direction away from the base substrate 10. For example, the first metal layer 301 and the third metal layer 303 may be a titanium layer, and the second metal layer 302 may be an aluminum layer. The film layers of the source electrode 2013 and the drain electrode 2014 of the transistor 201 are the same as the film layers of the first source-drain metal layer. That is, the source electrode 2013 and the drain electrode 2014 of the transistor 201 and the first source-drain metal layer each include a first metal layer 301, a second metal layer 302, and a third metal layer 303 that are stacked. In some examples, as shown in FIG. 7a, the first isolation portion 51 includes two film layers, namely, the first conductive layer 511 and the second conductive layer 512, wherein the first conductive layer 511 is made of the same material as the first metal layer 301, and the second conductive layer 512 is made of the same material as the second metal layer 302. In some other examples, as shown in FIG. 8, the first isolation portion 51 includes three film layers, namely, the first conductive layer 511, the second conductive layer 512, and the third conductive layer 513, wherein the first conductive layer 511 is made of the same material as the first metal layer 301, the second conductive layer 512 is made of the same material as the second metal layer 302, and the third conductive layer 513 is made of the same material as the third metal layer 303.

The first covering layer 52 and the fifth insulation layer 25 may be disposed in a same layer, and the fifth insulation layer 25 may have a single-layer structure or a multi-layer structure. When the fifth insulation layer 25 has a single-layer structure, the material of the first covering layer 52 is the same as the material of the fifth insulation layer 25. When the fifth insulation layer 25 has a multi-layer structure, the material of the first covering layer 52 may be the same as the material of any film layer of the fifth insulation layer 25, or the first covering layer 52 may include a plurality of film layers, and the material of the plurality of film layers of the first covering layer 52 may be the same as the material of the plurality of film layers of the fifth insulation layer 25. For example, the fifth insulation layer 25 may include a passivation layer 251 and a first planarization layer 252 sequentially stacked along a direction away from the base substrate 10, and the material of the first covering layer 52 may be the same as the material of the passivation layer 251 or the first planarization layer 252, or the first covering layer 52 may include two film layers, and the material of the two film layers is the same as the material of the passivation layer 251 and the first planarization layer 252, respectively. For another example, the fifth insulation layer 25 may include only the first planarization layer 252, and the material of the first covering layer 52 is the same as the material of the first planarization layer 252.

In some examples of the present embodiment, the second source-drain metal layer may include a plurality of metal layers that are stacked, and the first isolation portion 51 and the connection electrode 203 are disposed in a same layer. The film layers of the first isolation portion 51 and the film layers of the connection electrode 203 may be the same, or the number of film layers of the first isolation portion 51 may be less than the number of film layers of the connection electrode 203.

For example, the second source-drain metal layer may include a fourth metal layer 401, a fifth metal layer 402, and a sixth metal layer 403 sequentially stacked along a direction away from the base substrate 10. For example, the fourth metal layer 401 and the sixth metal layer 403 may be a titanium layer, and the fifth metal layer 402 may be an aluminum layer. The film layers of the connection electrode 203 are the same as the film layers of the second source-drain metal layer, that is, the connection electrode 203 and the second source-drain metal layer each include a fourth metal layer 401, a fifth metal layer 402, and a sixth metal layer 403 that are stacked. In some examples, as shown in FIG. 7a, the first isolation portion 51 includes two film layers, namely, the first conductive layer 511 and the second conductive layer 512, wherein the first conductive layer 511 is made of the same material as the fourth metal layer 401, and the second conductive layer 512 is made of the same material as the fifth metal layer 402. In some other examples, as shown in FIG. 8, the first isolation portion 51 includes three film layers, namely, the first conductive layer 511, the second conductive layer 512, and the third conductive layer 513, wherein the first conductive layer 511 is made of the same material as the fourth metal layer 401, the second conductive layer 512 is made of the same material as the fifth metal layer 402, and the third conductive layer 513 is made of the same material as the sixth metal layer 403.

The first covering layer 52 and the second planarization layer 26 may be disposed in a same layer and made of the same material.

In some examples of the present embodiment, as shown in FIGS. 9 and 10, the isolation post 50 includes a first isolation portion 51, a first covering layer 52, and a second isolation portion 53. The first isolation portion 51 and the connection electrode 203 may be disposed in a same layer, the first covering layer 52 and the second planarization layer 26 may be disposed in a same layer and made of the same material, and the second isolation portion 53 and the source electrode 2013 and the drain electrode 2014 of the transistor 201 may be disposed in a same layer.

For example, the first source-drain metal layer may include a first metal layer 301, a second metal layer 302, and a third metal layer 303 sequentially stacked along a direction away from the base substrate 10. For example, the first metal layer 301 and the third metal layer 303 may be a titanium layer, and the second metal layer 302 may be an aluminum layer. The film layers of the source electrode 2013 and the drain electrode 2014 of the transistor 201 are the same as the film layers of the first source-drain metal layer. That is, the source electrode 2013 and the drain electrode 2014 of the transistor 201 and the first source-drain metal layer each include a first metal layer 301, a second metal layer 302, and a third metal layer 303 that are stacked. The second isolation portion 53 includes a fourth conductive layer 531, a fifth conductive layer 532, and a sixth conductive layer 533 sequentially stacked along a direction away from the base substrate 10. The material of the fourth conductive layer 531 is the same as the material of the first metal layer 301, the material of the fifth conductive layer 532 is the same as the material of the second metal layer 302, and the material of the sixth conductive layer 533 is the same as the material of the third metal layer 303.

The second source-drain metal layer may include a fourth metal layer 401, a fifth metal layer 402, and a sixth metal layer 403 sequentially stacked along a direction away from the base substrate 10. For example, the fourth metal layer 401 and the sixth metal layer 403 may be a titanium layer, and the fifth metal layer 402 may be an aluminum layer. The film layers of the connection electrode 203 are the same as the film layers of the second source-drain metal layer, that is, the connection electrode 203 and the second source-drain metal layer each include a fourth metal layer 401, a fifth metal layer 402, and a sixth metal layer 403 that are stacked. In some examples, as shown in FIG. 9, the first isolation portion 51 includes two film layers, namely, the first conductive layer 511 and the second conductive layer 512, wherein the first conductive layer 511 is made of the same material as the fourth metal layer 401, and the second conductive layer 512 is made of the same material as the fifth metal layer 402. In some other examples, as shown in FIG. 10, the first isolation portion 51 includes three film layers, namely, the first conductive layer 511, the second conductive layer 512, and the third conductive layer 513, wherein the first conductive layer 511 is made of the same material as the fourth metal layer 401, the second conductive layer 512 is made of the same material as the fifth metal layer 402, and the third conductive layer 513 is made of the same material as the sixth metal layer 403.

In some examples of the present embodiment, as shown in FIG. 11, the isolation post 50 includes a first isolation portion 51 and a first covering layer 52, and a second isolation portion 53 and a second covering layer 54. The first isolation portion 51 and the connection electrode 203 may be disposed in a same layer, the first covering layer 52 and the second planarization layer 26 may be disposed in a same layer and made of the same material, and the second isolation portion 53 and the source electrode 2013 and the drain electrode 2014 of the transistor 201 may be disposed in a same layer, and the second covering layer 54 and the fifth insulation layer 25 may be disposed in a same layer. In the present example, the film layer structures of the first isolation portion 51 and the second isolation portion 53 may refer to the example of FIG. 10, and the film layer structure of the second covering layer 54 may refer to the film layer structure of the first covering layer 52 in the case where the first covering layer 52 and the fifth insulation layer 25 are disposed in a same layer in the foregoing example.

In some examples of the present embodiment, as shown in FIG. 2, the drive structure layer 20 may further include a semiconductor layer, a first gate metal layer and a second gate metal layer disposed on a side of the first source-drain metal layer facing the base substrate 10. The semiconductor layer includes an active layer 2011 of the transistor 201, the first gate metal layer may include a gate electrode 2012 of the transistor 201 and one plate of the storage capacitor 202, and the second gate metal layer may include the other plate of the storage capacitor 202.

The post base 55 may include one inorganic insulation layer or a plurality of inorganic insulation layers that are stacked. Alternatively, the post base 55 may include at least one inorganic insulation layer and at least one metal layer, and the metal layer may be covered by the inorganic insulation layer. For example, one of the inorganic insulation layers of the post base 55 and an insulation layer located between the first source-drain metal layer and the second gate metal layer may be disposed in a same layer and made of the same material. The metal layer in the post base 55 and the first gate metal layer or/and the second gate metal layer may be disposed in a same layer and may be made of the same material. For example, as shown in FIG. 7c, the post base 55 may include a seventh metal layer 555, a first inorganic insulation layer 553, an eighth metal layer 556, and a second inorganic insulation layer 554, which are sequentially stacked along a direction away from the base substrate. The first inorganic insulation layer 553 covers the seventh metal layer 555, and the second inorganic insulation layer 554 covers the eighth metal layer 556. The seventh metal layer 555 and the first gate metal layer may be disposed in a same layer and made of the same material, and the eighth metal layer 556 and the second gate metal layer may be disposed in a same layer and made of the same material.

In some exemplary embodiments, as shown in FIG. 2, the drive structure layer 20 includes a first insulation layer 21, a semiconductor layer, a second insulation layer 22, a first gate metal layer, a third insulation layer 23, a second gate metal layer, a fourth insulation layer 24, a first source-drain metal layer, a fifth insulation layer 25, a second source-drain metal layer, and a sixth insulation layer, which are sequentially stacked on the base substrate 10. The fifth insulation layer 25 may include a passivation layer 251 and a first planarization layer 252 sequentially stacked along a direction away from the base substrate 10, or the fifth insulation layer 25 may include only the first planarization layer 252. The sixth insulation layer is a second planarization layer 26. The first electrode 31 may be disposed on a surface of the second planarization layer 26 away from the base substrate 10.

For example, the base substrate 10 may be a flexible base substrate 10. For example, the base substrate 10 may include a polyimide (PI) material. Alternatively, the base substrate 10 may be a rigid base substrate 10, such as glass or the like.

For example, the first insulation layer 21, the second insulation layer 22, the third insulation layer 23, the fourth insulation layer 24, and the passivation layer 251 may be inorganic insulation layers, for example, may be any one or more of silicon oxide (SiO_{X}), silicon nitride (SiN_{X}), and silicon oxynitride (SiO_{X}N_{Y}), and may have a single-layer or multilayer structure. The first insulation layer 21 may be referred to as a buffer layer, which is used for improving capabilities of water-resistance and oxygen-resistance of the base substrate 10. The second insulation layer 22 and the third insulation layer 23 may be referred to as gate insulation (GI) layers. The fourth insulation layer 24 may be referred to as an interlayer insulation (ILD) layer. The first planarization layer 252 and the second planarization layer 26 are organic insulation layers, and may be made of an organic insulation material such as a resin. The first gate metal layer, the second gate metal layer, the first source-drain metal layer, and the second source-drain metal layer may be made of a metal material, such as any one or more of silver (Ag), copper (Cu), aluminum (Al), titanium (Ti), and molybdenum (Mo), or an alloy materials of the above metals, such as an Aluminum Neodymium (AlNd) alloy or a Molybdenum Niobium (MoNb) alloy, and may be of a single-layer structure or a multi-layer structure, such as stacked Ti/Al/Ti. The semiconductor layer may be made of various materials, such as amorphous Indium Gallium Zinc Oxide (a-IGZO), Zinc Oxynitride (ZnON), Indium Zinc Tin Oxide (IZTO), amorphous Silicon (a-Si), polycrystalline Silicon (p-Si), sexithiophene, and polythiophene. That is, the present disclosure is applicable to transistors 201 manufactured based on an oxide technology, a silicon technology, and an organic matter technology.

In some exemplary embodiments, as shown in FIG. 2, four isolation posts (an isolation post 50a, an isolation post 50b, an isolation post 50c, and an isolation post 50d) are illustrated in FIG. 2. The number of the isolation posts 50 may be unlimited, for example, one or more isolation posts may be provided, and the isolation posts 50 may be disposed on a side of the isolation dam 60 facing the display region 100 or/and a side of the isolation dam 60 facing the hole region 200. When the number of the isolation posts 50 is a plurality, the structures of the plurality of isolation posts 50 may be the same or different, and the plurality of isolation posts 50 may be any one or more of the isolation posts 50 illustrated in FIGS. 7a, 8, 9, 10, and 11. A side of the first isolation portions of the plurality of isolation posts 50 covered by the first covering layer may all face the display region or the hole region, or a side of the first isolation portion of at least one of the isolation posts 50 covered by the first covering layer may face the hole region, and a side of the first isolation portion of at least one of the isolation posts 50 covered by the first covering layer may face the display region.

In some exemplary embodiments, as shown in FIG. 2, the isolation dam 60 may include a first dam layer, a second dam layer, and a third dam layer that are sequentially stacked along a direction away from the base substrate 10. The first dam layer and the first planarization layer 252 may be disposed in a same layer and made of the same material, the second dam layer and the second planarization layer 26 may be disposed in a same layer and made of the same material, and the third dam layer and the pixel definition layer 32 may be disposed in a same layer and made of the same material. The isolation dam 60 may further include a dam base disposed on a side of the first dam layer facing the base substrate 10, and the dam base may include at least one inorganic insulation layer.

A structure of the display substrate will be described illustratively below through a preparation process of the display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and ink jet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. A "thickness" of a film layer is a dimension of the film layer in a direction perpendicular to the display substrate. In an exemplary implementation of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A overlaps with the boundary of the orthographic projection of B.

In some exemplary embodiments, the display substrate illustrated in FIG. 2 and the isolation post illustrated in FIG. 7a are taken as examples, and the first isolation portion 51 and the source electrode 2013 and the drain electrode 2014 of the transistor 201 are disposed in a same layer, and the first covering layer 52 and the passivation layer 251 in the fifth insulation layer 25 are disposed in a same layer. For example, the manufacturing process of the display substrate may include the following operations.
(1) Forming a drive structure layer 20 and film layers of an isolation post 50.

A first insulation thin film and a semiconductor thin film are sequentially deposited on a base substrate 10, and the semiconductor thin film is patterned by a patterning process to form a first insulation layer 21 overlaying the base substrate 10, and a pattern of a semiconductor layer disposed on the first insulation layer 21. The pattern of the semiconductor layer includes a plurality of active layers 2011 located in the display region 100. After this patterning process, the transition region 300 includes the first insulation layer 21 disposed on the base substrate 10. The above content may be understood with reference to FIG. 12a.

Then, a second insulation thin film and a first gate metal thin film are sequentially deposited, and the first gate metal thin film is patterned through the patterning processes to form a second insulation layer 22 overlaying the pattern of the semiconductor layer and a pattern of a first gate metal layer disposed on the second insulation layer 22. The pattern of the first gate metal layer includes a plurality of gate electrodes 2012 and a plurality of first plates 2021 located in the display region 100. After this patterning process, the transition region 300 includes a first insulation layer 21 and a second insulation layer 22 sequentially stacked on the base substrate 10. The above content may be understood with reference to FIG. 12a.

Subsequently, a third insulation thin film and a second gate metal thin film are sequentially deposited, and the second gate metal thin film is patterned by a patterning process to form a third insulation layer 23 overlaying the first gate metal layer, and a pattern of a second gate metal layer disposed on the third insulation layer 23. The pattern of the second gate metal layer includes a plurality of second plates 2022 located in the display region 100. The plurality of second plates 2022 and the plurality of first plates 2021 are arranged opposite to each other and form a plurality of storage capacitors 202. After this patterning process, the transition region 300 includes a first insulation layer 21, a second insulation layer 22, and a third insulation layer 23 sequentially stacked on the base substrate 10. The above content may be understood with reference to FIG. 12a.

Subsequently, a fourth insulation thin film is deposited, and the fourth insulation thin film is patterned by a patterning process to form a pattern of a fourth insulation layer 24 overlaying the pattern of the second gate metal layer. The pattern of the fourth insulation layer 24 includes a first post base layer 551 located in the transition region 300, the fourth insulation layer 24 of the display region 100 is provided with a plurality of first vias V1 and a plurality of second vias V2, the plurality of first vias V1 exposes one end of the plurality of active layers 2011, and the plurality of second vias V2 exposes the other end of the plurality of active layers 2011. After this patterning process, the transition region 300 includes a first insulation layer 21, a second insulation layer 22, and a third insulation layer 23 which are sequentially stacked on the base substrate 10, and a first post base layer 551 which is disposed on the third insulation layer 23. The above content may be understood with reference to FIG. 12a.

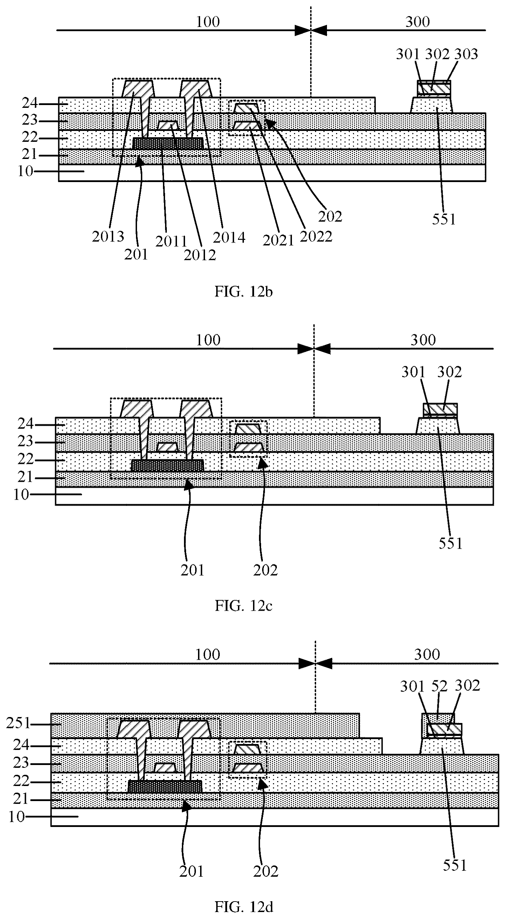

Subsequently, a first source-drain metal thin film is deposited, and the first source-drain metal thin film is patterned by a patterning process to form a pattern of a first source-drain metal layer on the fourth insulation layer 24. The pattern of the first source-drain metal layer includes a plurality of source electrodes 2013 and a plurality of drain electrodes 2014 located in the display region 100, and a first isolation layer located on the first post base layer 551 of the transition region 300. A source electrode 2013 is connected to one end of an active layer 2011 through a first via V1, and a drain electrode 2014 is connected to the other end of the active layer 2011 through a second via V2. The plurality of active layers 2011, the plurality of gate electrodes 2012, the plurality of source electrodes 2013, and the plurality of drain electrodes 2014 of the display region 100 form a plurality of transistors 201. The above contents may be understood with reference to FIG. 12b.

The first source-drain metal layer may include a first metal layer 301, a second metal layer 302, and a third metal layer 303 sequentially stacked along a direction away from the base substrate 10. For example, the first metal layer 301 and the third metal layer 303 may be a titanium layer, and the second metal layer 302 may be an aluminum layer. Then, the source electrode 2013, the drain electrode 2014, and the first isolation layer each include a first metal layer 301 (Ti), a second metal layer 302 (Al), and a third metal layer 303 (Ti) which are sequentially stacked along a direction away from the base substrate 10. Edges of the first metal layer 301, the second metal layer 302, and the third metal layer 303 of the first isolation layer may be substantially flush on a side of the first isolation layer facing the display region 100 and a side of the first isolation layer facing the hole region 200. The above contents may be understood with reference to FIG. 12b.

Herein, "edges of A and B are flush" means that edges of A and B are flush within the process error range, and are not absolutely flush.

Subsequently, the third metal layer 303 of the first isolation layer located in the transition region 300 is completely etched off using a mask by an etching process. The above contents may be understood with reference to FIG. 12c.

Subsequently, a passivation thin film is deposited, and the passivation thin film is patterned by a patterning process to form a pattern of a passivation layer 251 overlaying the pattern of the first source-drain metal layer. The pattern of the passivation layer 251 includes a first covering layer 52 located in the transition region 300, the first covering layer 52 is disposed on a surface of the second metal layer 302 of the first isolation layer away from the base substrate 10 and covers a side of the first isolation layer (such as the side facing the display region 100), and a portion of the surface of the second metal layer 302 of the first isolation layer away from the base substrate 10, which is close to the other side of the first isolation layer (such as the side facing the hole region 200), may not be overlaid by the first covering layer 52. The above contents may be understood with reference to FIG. 12d.

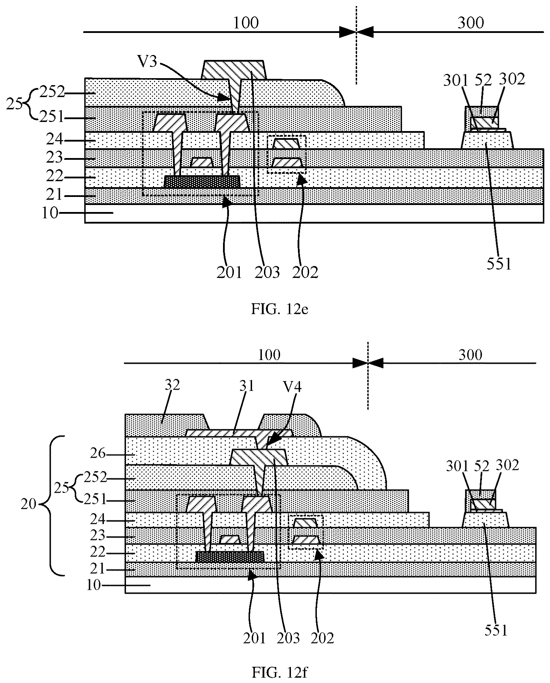

Subsequently, a first planarization thin film is coated, and the first planarization thin film is patterned by a patterning process to form a pattern of a first planarization layer 252 disposed on the passivation layer 251. The first planarization layer 252 is formed with a plurality of third vias V3 located in the display region 100, the first planarization layer 252 and the passivation layer 251 in the third vias V3 are removed and a surface of the drain electrode 2014 is exposed. The above contents may be understood with reference to FIG. 12e. In this example, an entirety of the passivation layer 251 and the first planarization layer 252 may be referred to as a fifth insulation layer 25, the passivation layer 251 may be made of an inorganic insulation material, and the first planarization layer 252 may be made of an organic insulation material. In other examples, the passivation layer 251 may not be provided, and the fifth insulation layer 25 may include only the first planarization layer 252, in which case, the first covering layer 52 may be formed simultaneously in the patterning process of forming the pattern of the first planarization layer 252.

Subsequently, a second source-drain metal thin film is deposited, and the second source-drain metal thin film is patterned by a patterning process to form a pattern of a second source-drain metal layer on the first planarization layer 252. The pattern of the second source-drain metal layer includes a plurality of anode connection electrodes 203 located in the display region 100, and the anode connection electrodes 203 are connected to the drain electrodes 2014 through the third vias V3. The above contents may be understood with reference to FIG. 12e.

The film layer structure and material of the second source-drain metal layer may be the same as the film layer structure and material of the first source-drain metal layer. For example, the second source-drain metal layer may include a fourth metal layer 401, a fifth metal layer 402, and a sixth metal layer 403 sequentially stacked along a direction away from the base substrate 10. For example, the fourth metal layer 401 and the sixth metal layer 403 may be a titanium layer, and the fifth metal layer 402 may be an aluminum layer. Therefore, during the patterning process of the second source-drain metal thin film, a portion of the first isolation layer of the transition region 300 that is not overlaid by the first covering layer 52 is also etched. After this patterning process is completed, a portion of the second metal layer 302 of the first isolation layer of the transition region 300 that is not overlaid by the first covering layer 52 is etched away. On a side of the first isolation layer that is not covered by the first covering layer 52, an edge of the second metal layer 302 of the first isolation layer is substantially flush with an edge of the first covering layer 52, and an edge of the first metal layer 301 of the first isolation layer protrudes from the edge of the second metal layer 302. Since the first metal layer 301 made of titanium of the first isolation layer is more difficult to etch than the second metal layer 302 made of aluminum, after the patterning process is completed, on the side of the first isolation layer that is not covered by the first covering layer 52, the edge of the first metal layer 301 of the first isolation layer protrudes from the edge of the second metal layer 302. The above contents may be understood with reference to FIG. 12e.

Subsequently, a second planarization thin film is coated, and the second planarization thin film is patterned by a patterning process to form a pattern of a second planarization layer 26 overlaying the pattern of the second source-drain metal layer. The second planarization layer 26 is formed with a plurality of fourth vias V4 located in the display region 100, and the second planarization layer 26 in the fourth vias V4 is removed and a surface of an anode connection electrode 203 is exposed. The above contents may be understood with reference to FIG. 12f.

Hereto, the manufacturing of the drive structure layer 20 and the film layers of the isolation post 50 is completed
(2) Forming a light emitting structure layer 30. In an exemplary embodiment, forming the light emitting structure layer 30 may include the following operations.

A first electrode thin film is deposited on the base substrate 10 where the aforementioned patterns are formed, and the first electrode thin film is patterned by a patterning process to form a pattern of a first electrode layer. The pattern of the first electrode layer includes a plurality of first electrodes 31 (anodes) located in the display region 100, and the first electrodes 31 are connected to the anode connection electrodes 203 through the fourth vias V4 on the second planarization layer 26, so that the first electrodes 31 are connected to the drain electrodes 2014 through the anode connection electrodes 203. The above contents may be understood with reference to FIG. 12f.

Subsequently, a pixel definition thin film is coated on the base substrate 10 where the aforementioned patterns are formed, and the pixel definition thin film is patterned by a patterning process to form a pattern of a pixel definition layer 32. The pixel definition layer 32 is provided with a plurality of pixel openings exposing a surface of the first electrode 31 of the display region 100. The above contents may be understood with reference to FIG. 12f.

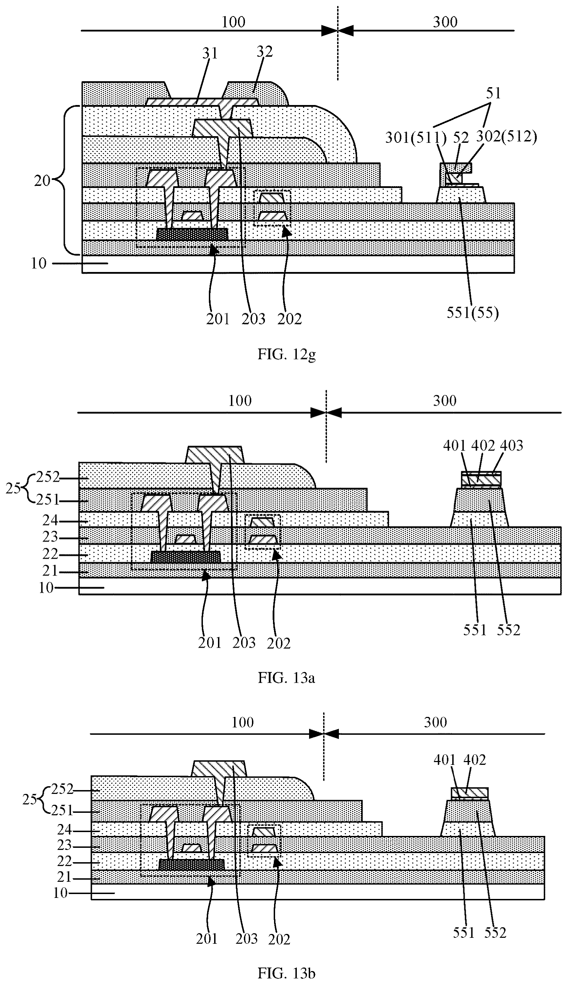

Subsequently, the second metal layer 302 of the first isolation layer of the transition region 300 may be transversely etched using a mask by a wet etching process, so that the second metal layer 302 of the first isolation layer partially shrinks inward relative to the first covering layer 52 on a side of the first isolation layer that is not covered by the first covering layer 52. Thus, the final structure of the isolation post 50 is formed, and the first metal layer 301 and the second metal layer 302 of the first isolation layer become the first conductive layer 511 and the second conductive layer 512 of the first isolation portion 51 of the isolation post 50, and the first post base layer 551 forms the post base 55. The above contents may be understood with reference to FIG. 12g.

Subsequently, on the base substrate 10 where the aforementioned patterns are formed, a spacer post thin film is coated, and the spacer post thin film is patterned by a patterning process to form a pattern of a spacer post layer. The pattern of the spacer post layer includes a plurality of spacer posts (not shown) located on the pixel definition layer 32 of the display region 100.

Subsequently, on the base substrate 10 where the aforementioned patterns are formed, a plurality of film layers of a light emitting functional layer 33 may be sequentially formed by an evaporation process. The light emitting functional layer 33 may include a hole injection layer, a hole transporting layer, an electron blocking layer, an organic light emitting layer, a hole blocking layer, an electron transporting layer, and an electron injection layer, which are sequentially disposed along a direction away from the base substrate. Except for the organic light emitting layer, the remaining film layers of the light emitting functional layer 33 may have an integrated monolithic structure, that is, the remaining film layers of the light emitting functional layer 33 may be common layers for sub-pixels of different colors, and these common layers may be formed in the display region 100 and the transition region 300 at the time of evaporation. Since the isolation posts 50 are provided in the transition region 300, these common layers are disconnected at the isolation posts 50, blocking the transmission path of water and oxygen from the hole region 200 to the display region 100 through the light emitting functional layer 33, and preventing water and oxygen from eroding the light emitting functional layer 33 of the display region 100. The above contents may be understood with reference to FIG. 2.

Subsequently, on the base substrate 10 where the aforementioned patterns are formed, a second electrode (cathode) layer is formed by an evaporation process. The second electrode layer 34 of sub-pixels of different colors is a common layer connected as an integrated structure, and the second electrode layer 34 may be formed in the display region 100 and the transition region 300. The second electrode layer 34 may be disconnected at the isolation post 50, blocking the transmission path of water and oxygen from the hole region 200 to the display region 100 through the second electrode layer 34, and preventing water and oxygen from eroding the second electrode layer 34 of the display region 100. The above contents may be understood with reference to FIG. 2.

Hereto, manufacturing of the light emitting structure layer 30 is completed.

(3) Forming an encapsulation structure layer 40. In an exemplary embodiment, forming the encapsulation structure layer 40 may include the following operations.

On the base substrate 10 where the aforementioned patterns are formed, a first encapsulation thin film is first deposited using an open mask by a deposition method to form a first encapsulation layer 41 located in the display region 100 and the transition region 300. Subsequently, a second encapsulation material is printed using an open mask by an ink jet printing process to form a second encapsulation layer 42 located in the display region 100 and the transition region 300. The isolation dam 60 of the transition region 300 may block ink overflow during the ink jet printing process. Subsequently, a third encapsulation thin film is deposited using an open mask by a deposition method to form a third encapsulation layer 43 located in the display region 100 and the transition region 300. The first encapsulation layer 41 and the third encapsulation layer 243 may be made of an inorganic material, and the second encapsulation layer 42 may be made of an organic material. The above contents may be understood with reference to FIG. 2.

Subsequently, film layers such as a touch structure layer and a color film layer may be sequentially formed on a side of the encapsulation structure layer 40 away from the base substrate 10.

In other exemplary embodiments, the display substrate illustrated in FIG. 2 and the isolation post illustrated in FIG. 7a are taken as examples, and the first isolation portion 51 and the connection electrode 203 are disposed in a same layer, and the first covering layer 52 and the second planarization layer 26 are disposed in a same layer. For example, the manufacturing process of the display substrate may include the following operations.
(1) Forming a drive structure layer 20 and film layers of an isolation post 50.

A first insulation thin film and a semiconductor thin film are sequentially deposited on the base substrate 10, and the semiconductor thin film is patterned by a patterning process to form a first insulation layer 21 overlaying the base substrate 10, and a pattern of a semiconductor layer disposed on the first insulation layer 21. The semiconductor layer pattern includes a plurality of active layers 2011 located in the display region 100. After this patterning process, the transition region 300 includes the first insulation layer 21 disposed on the base substrate 10. The above content may be understood with reference to FIG. 13a.

Then, a second insulation thin film and a first gate metal thin film are sequentially deposited, and the first gate metal thin film is patterned by a patterning process to form a second insulation layer 22 overlaying the pattern of the semiconductor layer and a pattern of a first gate metal layer disposed on the second insulation layer 22. The pattern of the first gate metal layer includes a plurality of gate electrodes 2012 and a plurality of first plates 2021 located in the display region 100. After this patterning process, the transition region 300 includes the first insulation layer 21 and the second insulation layer 22 sequentially stacked on the base substrate 10. The above content may be understood with reference to FIG. 13a.

Subsequently, a third insulation thin film and a second gate metal thin film are sequentially deposited, and the second gate metal thin film is patterned by a patterning process to form a third insulation layer 23 overlaying the first gate metal layer, and a pattern of a second gate metal layer disposed on the third insulation layer 23. The pattern of the second gate metal layer includes a plurality of second plates 2022 located in the display region 100. The plurality of second plates 2022 and the plurality of first plates 2021 are arranged opposite to each other and form a plurality of storage capacitors 202. After this patterning process, the transition region 300 includes the first insulation layer 21, the second insulation layer 22, and the third insulation layer 23 sequentially stacked on the base substrate 10. The above content may be understood with reference to FIG. 13a.

Subsequently, a fourth insulation thin film is deposited, and the fourth insulation thin film is patterned by a patterning process to form a pattern of a fourth insulation layer 24 overlaying the pattern of the second gate metal layer. The pattern of the fourth insulation layer 24 includes a first post base layer 551 located in the transition region 300. The fourth insulation layer 24 of the display region 100 is provided with a plurality of first vias and a plurality of second vias, the plurality of first vias expose one end of the plurality of active layers 2011, and the plurality of second vias expose the other end of the plurality of active layers 2011. After this patterning process, the transition region 300 includes the first insulation layer 21, the second insulation layer 22, and the third insulation layer 23 which are sequentially stacked on the base substrate 10, and the first post base layer 551 which is disposed on the third insulation layer 23. The above content may be understood with reference to FIG. 13a.

Subsequently, a first source-drain metal thin film is deposited, and the first source-drain metal thin film is patterned by a patterning process to form a pattern of a first source-drain metal layer on the fourth insulation layer 24. The pattern of the first source-drain metal layer includes a plurality of source electrodes 2013 and a plurality of drain electrodes 2014 located in the display region 100, a source electrode 2013 is connected to one end of an active layer 2011 through a first via, and a drain electrode 2014 is connected to the other end of the active layer 2011 through a second via. The plurality of active layers 2011, the plurality of gate electrodes 2012, the plurality of source electrodes 2013, and the plurality of drain electrodes 2014 of the display region 100 form the plurality of transistors 201. The above content may be understood with reference to FIG. 13a.

Subsequently, a passivation thin film is deposited, and the passivation thin film is patterned by a patterning process to form a pattern of a passivation layer 251 overlaying the pattern of the first source-drain metal layer. The pattern of the passivation layer 251 includes a second post base layer 552 located on the first post base layer 551 of the transition region 300. The above content may be understood with reference to FIG. 13a.

Subsequently, a first planarization thin film is coated, and the first planarization thin film is patterned by a patterning process to form a pattern of a first planarization layer 252 disposed on the passivation layer 251. The first planarization layer 252 is formed with a plurality of third vias located in the display region 100, the first planarization layer 252 and the passivation layer 251 in the third vias are removed and a surface of the drain electrode 2014 is exposed. The above content may be understood with reference to FIG. 13a.

Subsequently, a second source-drain metal thin film is deposited, and the second source-drain metal thin film is patterned by a patterning process to form a pattern of a second source-drain metal layer on the first planarization layer 252. The pattern of the second source-drain metal layer includes a plurality of anode connection electrodes 203 located in the display region 100, and a first isolation layer located on the second post base layer 552 of the transition region 300. The anode connection electrodes 203 are connected to the drain electrodes 2014 through the third vias. The above content may be understood with reference to FIG. 13a.

The second source-drain metal layer may include a fourth metal layer 401, a fifth metal layer 402, and a sixth metal layer 403 sequentially stacked along a direction away from the base substrate 10. For example, the fourth metal layer 401 and the sixth metal layer 403 may be a titanium layer, and the fifth metal layer 402 may be an aluminum layer. Then, the film layers of the anode connection electrode 203 and the film layers of the first isolation layer are the same as the film layers of the second source-drain metal layer, that is, the anode connection electrode 203, the first isolation layer and the second source-drain metal layer each include a fourth metal layer 401, a fifth metal layer 402, and a sixth metal layer 403 that are stacked. Edges of the fourth metal layer 401, the fifth metal layer 402, and the sixth metal layer 403 of the first isolation layer may be substantially flush on a side of the first isolation layer facing the display region 100 and a side of the first isolation layer facing the hole region 200. The above content may be understood with reference to FIG. 13a.

Subsequently, the sixth metal layer 403 of the first isolation layer located in the transition region 300 is completely etched off using a mask by an etching process. The above contents may be understood with reference to FIG. 13b.

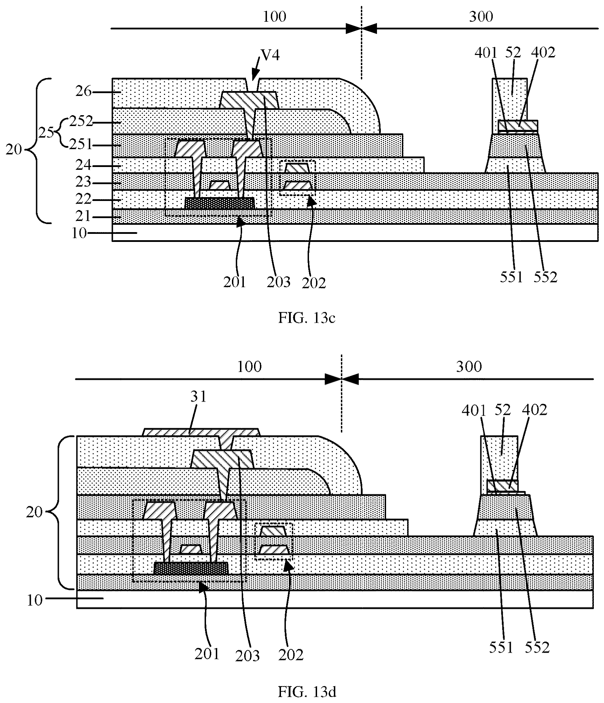

Subsequently, a second planarization thin film is coated and patterned using a patterning process to form a pattern of a second planarization layer 26 overlaying the pattern of the second source-drain metal layer. The second planarization layer 26 is formed with a plurality of fourth vias V4 located in the display region 100, and the second planarization layer 26 within the fourth vias V4 is removed and a surface of the anode connection electrode 203 is exposed. The pattern of the second planarization layer 26 includes a first covering layer 52 located in the transition region 300, and the first covering layer 52 is disposed on a surface of the fifth metal layer 402 of the first isolation layer away from the base substrate 10 and covers a side of the first isolation layer (such as a side facing the display region 100). A portion of the surface of the fifth metal layer 402 of the first isolation layer away from the base substrate 10, which is close to the other side of the first isolation layer (such as a side facing the hole region 200), may not be overlaid by the first covering layer 52. The above contents may be understood with reference to FIG. 13c.

Hereto, the manufacturing of the drive structure layer 20 and the film layers of the isolation post 50 is completed
(2) Forming a light emitting structure layer 30. In an exemplary embodiment, forming the light emitting structure layer 30 may include the following operations.

A first electrode thin film is deposited on the base substrate 10 where the aforementioned patterns are formed, and the first electrode thin film is patterned by a patterning process to form a pattern of a first electrode layer. The pattern of the first electrode layer includes a plurality of first electrodes 31 (anodes) located in the display region 100, and the first electrodes 31 are connected to the anode connection electrodes 203 through the fourth vias on the second planarization layer 26, so that the first electrodes 31 are connected to the drain electrodes 2014 through the anode connection electrodes 203. The above contents may be understood with reference to FIG. 13d.

In the patterning process of the first electrode thin film, a portion of the first isolation layer of the transition region 300 that is not overlaid by the first covering layer 52 is also etched. After this patterning process is completed, a portion of the fifth metal layer 402 of the first isolation layer of the transition region 300 that is not overlaid by the first covering layer 52 may be etched away. On a side of the first isolation layer that is not covered by the first covering layer 52, an edge of the fifth metal layer 402 of the first isolation layer may be substantially flush with an edge of the first covering layer 52, and an edge of the fourth metal layer 401 of the first isolation layer protrudes from the edge of the fifth metal layer 402. Since the fourth metal layer 401 made of titanium of the first isolation layer is more difficult to etch than the fifth metal layer 402 made of aluminum, after this patterning process is completed, on the side of the first isolation layer that is not covered by the first covering layer 52, the edge of the fourth metal layer 401 of the first isolation layer may protrude from the edge of the fifth metal layer 402. The above contents may be understood with reference to FIG. 13d.

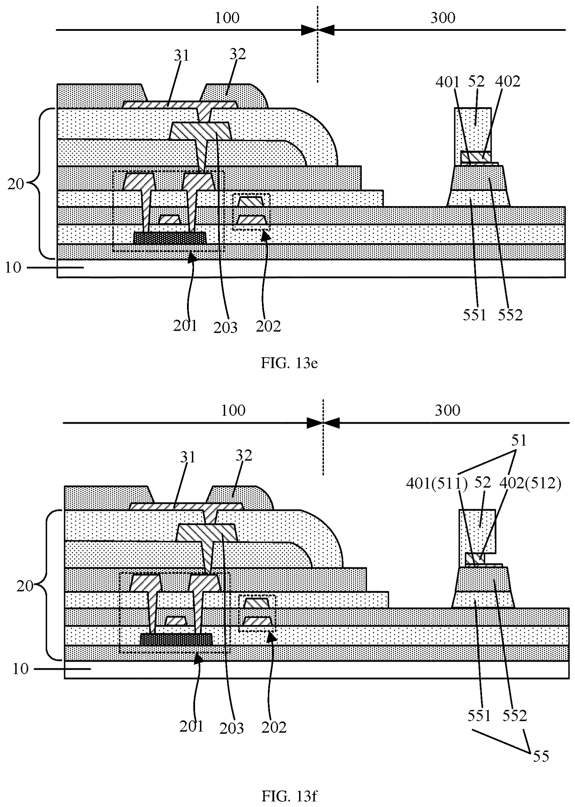

Subsequently, a pixel definition thin film is coated on the base substrate 10 where the aforementioned patterns are formed, and the pixel definition thin film is patterned by a patterning process to form a pattern of a pixel definition layer 32. The pixel definition layer 32 is provided with a plurality of pixel openings exposing a surface of the first electrode 31 of the display region 100. The above contents may be understood with reference to FIG. 13e.

Subsequently, the fifth metal layer 402 of the first isolation layer of the transition region 300 may be transversely etched using a mask by a wet etching process, so that the fifth metal layer 402 of the first isolation layer partially shrinks inward relative to the first covering layer 52 on a side of the first isolation layer that is not covered by the first covering layer 52. Thus, the final structure of the isolation post 50 is formed, and the fourth metal layer 401 and the fifth metal layer 402 of the first isolation layer become the first conductive layer 511 and the second conductive layer 512 of the first isolation portion 51 of the isolation post 50, and the first post base layer 551 and the second post base layer 552 form the post base 55. The above contents may be understood with reference to FIG. 13f.

Subsequently, on the base substrate 10 where the aforementioned patterns are formed, a spacer post thin film is coated, and the spacer post thin film is patterned by a patterning process to form a pattern of a spacer post layer. The pattern of the spacer post layer includes a plurality of spacer posts (not shown) located on the pixel definition layer 32 of the display region 100.

Subsequently, on the base substrate 10 where the aforementioned patterns are formed, a plurality of film layers of a light emitting functional layer 33 may be sequentially formed by an evaporation process. The light emitting functional layer 33 may include a hole injection layer, a hole transporting layer, an electron blocking layer, an organic light emitting layer, a hole blocking layer, an electron transporting layer, and an electron injection layer, which are sequentially disposed along a direction away from the base substrate. Except for the organic light emitting layer, the remaining film layers of the light emitting functional layer 33 may have an integrated monolithic structure. That is, the remaining film layers of the light emitting functional layer 33 may be common layers for sub-pixels of different colors, and these common layers may be formed in the display region 100 and the transition region 300 at the time of evaporation. Since the isolation posts 50 are provided in the transition region 300, these common layers are disconnected at the isolation posts 50, blocking the transmission path of water and oxygen from the hole region 200 to the display region 100 through the light emitting functional layer 33, and preventing water and oxygen from eroding the light emitting functional layer 33 of the display region 100. The above contents may be understood with reference to FIG. 2.

Subsequently, on the base substrate 10 where the aforementioned patterns are formed, a second electrode (cathode) layer is formed by an evaporation process. The second electrode layer 34 of sub-pixels of different colors is a common layer connected as an integrated structure, and the second electrode layer 34 may be formed in the display region 100 and the transition region 300. The second electrode layer 34 may be disconnected at the isolation post 50, blocking the transmission path of water and oxygen from the hole region 200 to the display region 100 through the second electrode layer 34, and preventing water and oxygen from eroding the second electrode layer 34 of the display region 100. The above contents may be understood with reference to FIG. 2.

Hereto, the manufacturing of the light emitting structure layer 30 is completed.

Subsequently, film layers such as an encapsulation structure layer 40, a touch structure layer, and a color film layer may be sequentially formed on a side of the light emitting structure layer 30 away from the base substrate 10.

Based on the process of FIGS. 12a to 12g or the process of FIGS. 13a to 13f, an embodiment of the present disclosure provides a manufacturing method for a display substrate, including manufacturing an isolation post illustrated in FIG. 7a. The manufacturing process of the isolation post illustrated in FIG. 7a may include:
forming a first isolation layer on the base substrate of the transition region, wherein the first isolation layer includes a first film layer, a second film layer, and a third film layer sequentially stacked along a direction away from the base substrate, and edges of the first film layer, the second film layer, and the third film layer are flush on a side of the first isolation layer facing the display region and a side of the first isolation layer facing the hole region;
completely removing the third film layer by an etching process;
forming a first covering layer on a surface of the second film layer away from the base substrate, wherein the first covering layer covers a side of the first isolation layer facing the display region or the hole region, and on a side of the first isolation layer that is not covered by the first covering layer, edges of the second film layer and the first film layer protrude from an edge of the first covering layer;
etching the first isolation layer by an etching process so that on the side of the first isolation layer that is not covered by the first covering layer, the edge of the second film layer is flush with the edge of the first covering layer, and the edge of the first film layer protrudes from the edge of the second film layer or is flush with the edge of the second film layer; and
etching the second film layer by an etching process so that on the side of the first isolation layer that is not covered by the first covering layer, the edge of the second film layer shrinks inward relative to the edge of the first covering layer and the edge of the first film layer, thereby making the first film layer and the second film layer of the first isolation layer become the first conductive layer and the second conductive layer of the first isolation portion, respectively.

In still some other exemplary embodiments, the display substrate illustrated in FIG. 2 and the isolation post illustrated in FIG. 8 are taken as examples, and the first isolation portion 51 and the source electrode 2013 and the drain electrode 2014 of the transistor 201 are disposed in a same layer, and the first covering layer 52 and the passivation layer 251 in the fifth insulation layer 25 are disposed in a same layer. For example, the manufacturing process of the display substrate may include the following operations.
(1) Forming a drive structure layer 20 and film layers of an isolation post 50.

A first insulation layer 21, a semiconductor layer, a second insulation layer 22, a first gate metal layer, a third insulation layer 23, a second gate metal layer, and a fourth insulation layer 24 are sequentially formed on the base substrate 10.

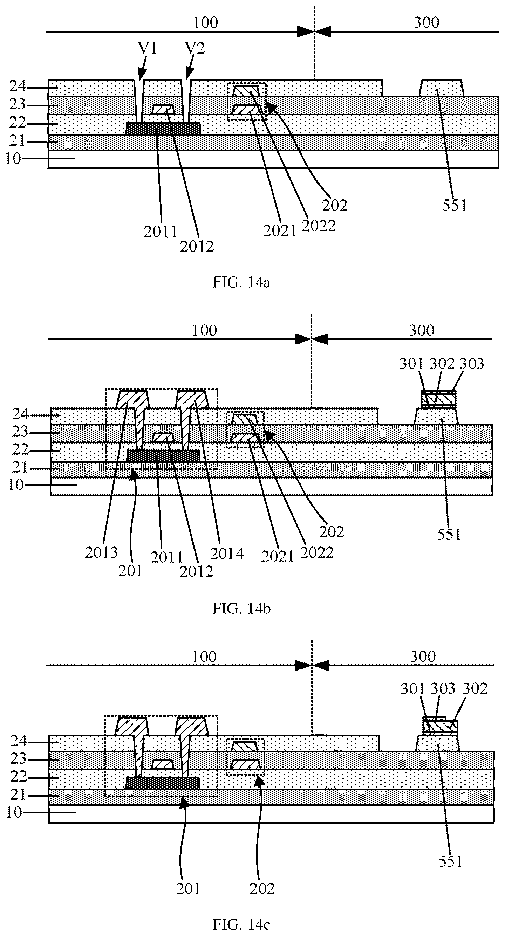

A first post base layer 551 is formed on the third insulation layer 23 of the transition region 300 while forming the fourth insulation layer 24 of the display region 100, that is, the first post base layer 551 and the fourth insulation layer 24 are disposed in a same layer and made of the same material. The fourth insulation layer 24 of the display region 100 is provided with a plurality of first vias V1 exposing one end of the plurality of active layers 2011 and a plurality of second vias V2 exposing the other end of the plurality of active layers 2011. The above content may be understood with reference to FIG. 14a.

Subsequently, a first source-drain metal thin film is deposited, and the first source-drain metal thin film is patterned by a patterning process to form a pattern of a first source-drain metal layer on the fourth insulation layer 24. The pattern of the first source-drain metal layer includes a plurality of source electrodes 2013 and a plurality of drain electrodes 2014 located in the display region 100, and a first isolation layer located on the first post base layer 551 of the transition region 300. A source electrode 2013 is connected to one end of an active layer 2011 through a first via, and a drain electrode 2014 is connected to the other end of the active layer 2011 through a second via. The plurality of active layers 2011, the plurality of gate electrodes 2012, the plurality of source electrodes 2013, and the plurality of drain electrodes 2014 of the display region 100 form a plurality of transistors 201. The above contents may be understood with reference to FIG. 14b.

The first source-drain metal layer may include a first metal layer 301, a second metal layer 302, and a third metal layer 303 sequentially stacked along a direction away from the base substrate 10. For example, the first metal layer 301 and the third metal layer 303 may be a titanium layer, and the second metal layer 302 may be an aluminum layer. Then, the source electrode 2013, the drain electrode 2014, and the first isolation layer each include a first metal layer 301 (Ti), a second metal layer 302 (Al), and a third metal layer 303 (Ti) which are sequentially stacked along a direction away from the base substrate 10. Edges of the first metal layer 301, the second metal layer 302, and the third metal layer 303 of the first isolation layer may be substantially flush on a side of the first isolation layer facing the display region 100 and a side of the first isolation layer facing the hole region 200. The above contents may be understood with reference to FIG. 14b.

Subsequently, a portion of the third metal layer 303 of the first isolation layer of the transition region 300 close to the display region 100 or the hole region 200 ( the portion close to the hole region 200 in the example of FIG. 14c) is etched away using a mask by an etching process. The above contents may be understood with reference to FIG. 14c.

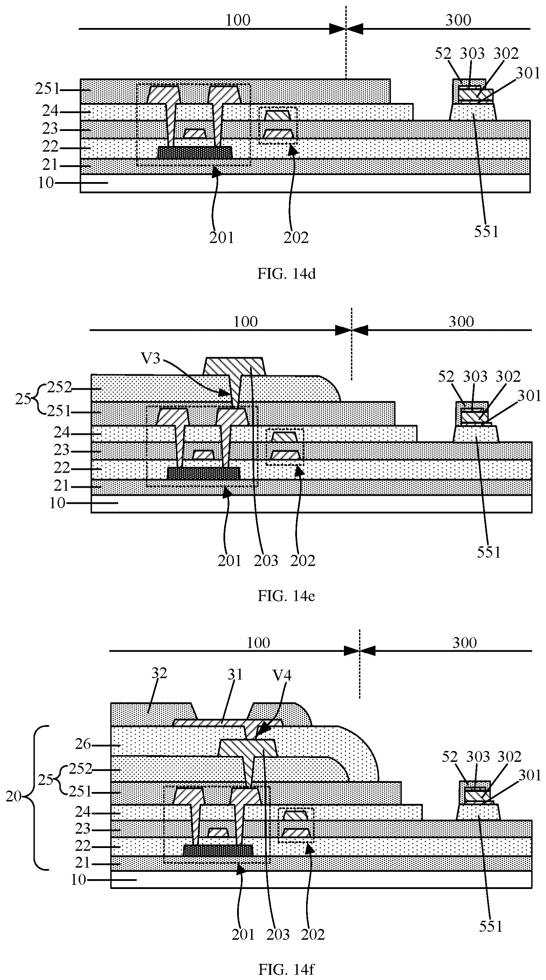

Subsequently, a passivation thin film is deposited, and the passivation thin film is patterned by a patterning process to form a pattern of a passivation layer 251 overlaying the pattern of the first source-drain metal layer. The pattern of the passivation layer 251 includes a first covering layer 52 located in the transition region 300. The first covering layer 52 is disposed on a surface of the third metal layer 303 of the first isolation layer away from the base substrate 10 and covers a side of the first isolation layer facing the display region 100, and covers a surface of the third metal layer 303 away from the base substrate 10 and a surface of the third metal layer 303 located on a side of the first isolation layer facing the hole region 200 (i.e., a surface of the third metal layer 303 facing the hole region 200). A portion of the surface of the second metal layer 302 of the first isolation layer away from the base substrate 10, which is close to the hole region 200, may not be overlaid by the first covering layer 52. That is, on a side of the first isolation layer that is not covered by the first covering layer 52, an edge of the second metal layer 302 of the first isolation layer may protrude from an edge of the first covering layer 52. The above contents may be understood with reference to FIG. 14d.

Subsequently, a first planarization thin film is coated, and the first planarization thin film is patterned by a patterning process to form a pattern of a first planarization layer 252 disposed on the passivation layer 251. The first planarization layer 252 is formed with a plurality of third vias V3 located in the display region 100, and the first planarization layer 252 and the passivation layer 251 in the third vias V3 are removed and a surface of the drain electrode 2014 is exposed. The above contents may be understood with reference to FIG. 14e. In this example, an entirety of the passivation layer 251 and the first planarization layer 252 may be referred to as a fifth insulation layer 25, the passivation layer 251 may be made of an inorganic insulation material, and the first planarization layer 252 may be made of an organic insulation material. In other examples, the passivation layer 251 may not be provided, and the fifth insulation layer 25 may include only the first planarization layer 252, in which case, the first covering layer 52 may be formed simultaneously in the patterning process of forming the pattern of the first planarization layer 252.

Subsequently, a second source-drain metal thin film is deposited, and the second source-drain metal thin film is patterned by a patterning process to form a pattern of a second source-drain metal layer on the first planarization layer 252. The pattern of the second source-drain metal layer includes a plurality of anode connection electrodes 203 located in the display region 100, and the anode connection electrodes 203 are connected to the drain electrodes 2014 through the third vias V3. The above contents may be understood with reference to FIG. 14e.

The film layer structure and material of the second source-drain metal layer may be the same as the film layer structure and material of the first source-drain metal layer. For example, the second source-drain metal layer may include a fourth metal layer 401, a fifth metal layer 402, and a sixth metal layer 403 sequentially stacked along a direction away from the base substrate 10. For example, the fourth metal layer 401 and the sixth metal layer 403 may be a titanium layer, and the fifth metal layer 402 may be an aluminum layer. Therefore, during the patterning process of the second source-drain metal thin film, a portion of the first isolation layer of the transition region 300 that is not overlaid by the first covering layer 52 is also etched. After this patterning process is completed, a portion of the second metal layer 302 of the first isolation layer of the transition region 300 that is not overlaid by the first covering layer 52 is etched away. On a side of the first isolation layer that is not covered by the first covering layer 52, an edge of the second metal layer 302 of the first isolation layer is substantially flush with an edge of the first covering layer 52, and an edge of the first metal layer 301 of the first isolation layer protrudes from the edge of the second metal layer 302. Since the first metal layer 301 made of titanium of the first isolation layer is more difficult to etch than the second metal layer 302 made of aluminum, after the patterning process is completed, on the side of the first isolation layer that is not covered by the first covering layer 52, the edge of the first metal layer 301 of the first isolation layer protrudes from the edge of the second metal layer 302. The above contents may be understood with reference to FIG. 14e.

Subsequently, a second planarization thin film is coated, and the second planarization thin film is patterned by a patterning process to form a pattern of a second planarization layer 26 overlaying the pattern of the second source-drain metal layer. The second planarization layer 26 is formed with a plurality of fourth vias V4 located in the display region 100, and the second planarization layer 26 in the fourth vias V4 is removed and a surface of an anode connection electrode 203 is exposed. The above contents may be understood with reference to FIG. 14f.

Hereto, the manufacturing of the drive structure layer 20 and the film layers of the isolation post 50 is completed.

(2) Forming a light emitting structure layer 30. In an exemplary embodiment, forming the light emitting structure layer 30 may include the following operations.

A first electrode thin film is deposited on the base substrate 10 where the aforementioned patterns are formed, and the first electrode thin film is patterned by a patterning process to form a pattern of a first electrode layer. The pattern of the first electrode layer includes a plurality of first electrodes 31 (anodes) located in the display region 100, and the first electrodes 31 are connected to the anode connection electrodes 203 through the fourth vias V4 on the second planarization layer 26, so that the first electrodes 31 are connected to the drain electrodes 2014 through the anode connection electrodes 203. The above contents may be understood with reference to FIG. 14f.

Subsequently, a pixel definition thin film is coated on the base substrate 10 where the aforementioned patterns are formed, and the pixel definition thin film is patterned by a patterning process to form a pattern of a pixel definition layer 32. The pixel definition layer 32 is provided with a plurality of pixel openings exposing a surface of the first electrode 31 of the display region 100. The above contents may be understood with reference to FIG. 14f.

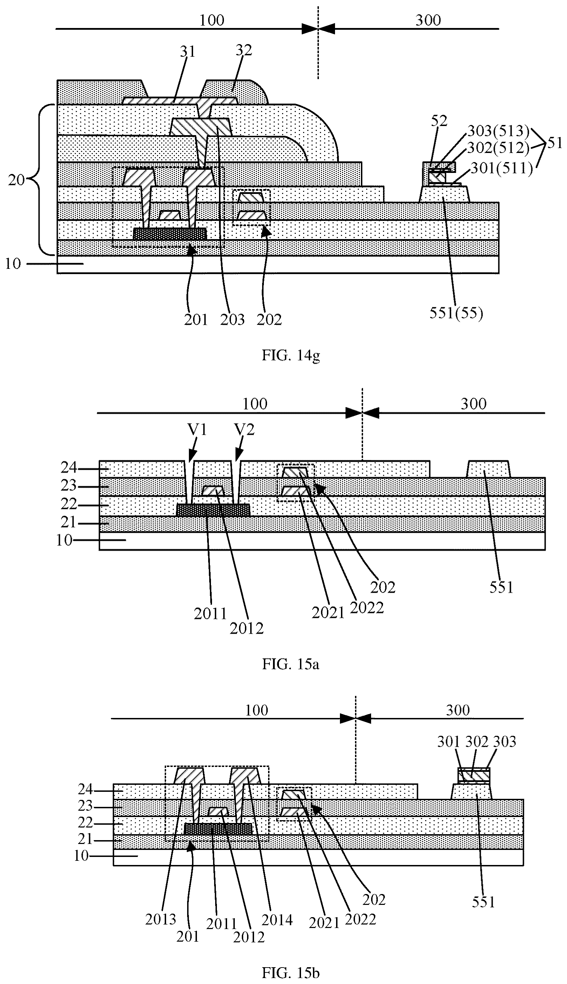

Subsequently, the second metal layer 302 of the first isolation layer of the transition region 300 may be transversely etched using a mask by a wet etching process, so that the second metal layer 302 of the first isolation layer partially shrinks inward relative to the third metal layer 303 on a side of the first isolation layer that is not covered by the first covering layer 52. Thus, the final structure of the isolation post 50 is formed, and the first metal layer 301, the second metal layer 302, and the third metal layer 303 of the first isolation layer become the first conductive layer 511, the second conductive layer 512, and the third conductive layer 513 of the first isolation portion 51 of the isolation post 50, and the first post base layer 551 forms the post base 55. The above contents may be understood with reference to FIG. 14g.

Subsequently, the remaining film layers of the display substrate are formed.

The process of FIGS. 14a to 14g described above forms the isolation post 50 illustrated in FIG. 8, and the first isolation portion 51 and the source electrode 2013 and the drain electrode 2014 of the transistor 201 are disposed in a same layer, and the first covering layer 52 and the passivation layer 251 in the fifth insulation layer 25 are disposed in a same layer. In other embodiments, in the isolation post 50 illustrated in FIG. 8, the first isolation portion 51 and the connection electrode 203 are disposed in a same layer, the first covering layer 52 and the second planarization layer 26 are disposed in a same layer, and the mode of forming the isolation post 50 may be the same as that of forming the isolation post 50 in FIGS. 14a to 14g. In this case, the connection electrode 203 may be formed in the display region 100 and the first isolation layer may be formed in the transition region 300 while the pattern of the second source-drain metal layer is formed by patterning. The second source-drain metal layer may include the fourth metal layer 401, the fifth metal layer 402, and the sixth metal layer 402 sequentially stacked along a direction away from the base substrate 10. For example, the fourth metal layer 401 and the sixth metal layer 403 may be a titanium layer, and the fifth metal layer 402 may be aluminum layer. Then the first isolation layer includes the fourth metal layer 401, the fifth metal layer 402 and the sixth metal layer 403 sequentially stacked along a direction away from the base substrate 10. Subsequently, a portion of the sixth metal layer 403 of the first isolation layer located in the transition region 300 close to the display region 100 or the hole region 200 is etched away using a mask by an etching process. Subsequently, the first covering layer 52 is formed on the sixth metal layer 403 of the first isolation layer of the transition region 300 while forming the pattern of the second planarization layer 26 by patterning. Subsequently, while forming the first electrode 31 by patterning, a portion of the fifth metal layer 402 of the first isolation layer that is not overlaid by the first covering layer 52 is etched and removed, and on a side of the first isolation layer that is not covered by the first covering layer 52, an edge of the fifth metal layer 402 of the first isolation layer may be substantially flush with an edge of the first covering layer 52, and an edge of the fourth metal layer 401 protrudes from the edge of the fifth metal layer 402. Subsequently, the fifth metal layer 402 of the first isolation layer of the transition region 300 can be transversely etched using a mask by a wet etching process, so that the fifth metal layer 402 of the first isolation layer partially shrinks inward relative to the sixth metal layer 403 on the side of the first isolation layer that is not covered by the first covering layer 52. Thus, the final structure of the isolation post 50 is formed, and the fourth metal layer 401, the fifth metal layer 402, and the sixth metal layer 403 of the first isolation layer become the first conductive layer 511, the second conductive layer 512, and the third conductive layer 513 of the first isolation portion 51 of the isolation post 50.

Based on the process of FIGS. 14a to 14g, an embodiment of the present disclosure provides a manufacturing method for a display substrate, including manufacturing an isolation post illustrated in FIG. 8. The manufacturing process of the isolation post illustrated in FIG. 8 may include:
forming a first isolation layer on the base substrate of the transition region, wherein the first isolation layer includes a first film layer, a second film layer, and a third film layer sequentially stacked along a direction away from the base substrate, and edges of the first film layer, the second film layer, and the third film layer are flush on a side of the first isolation layer facing the display region and a side of the first isolation layer facing the hole region;
etching and removing a portion of the third film layer close to the display region or the hole region by an etching process so that edges of the first film layer and the second film layer protrude from edges of the third film layer on a first side of the first isolation layer;
forming a first covering layer on a surface of the third film layer away from the base substrate, wherein the first covering layer covers a second side of the first isolation layer, and covers a surface of the third film layer away from the base substrate and a surface of the third film layer located on the first side of the first isolation layer;
etching the first isolation layer by an etching process, so that on a side of the first isolation layer that is not covered by the first covering layer (i.e., the first side of the first isolation layer), the edge of the second film layer is flush with the edge of the first covering layer and the edge of the first film layer protrudes from the edge of the second film layer or is flush with the edge of the second film layer; and
etching the second film layer by an etching process so that on the side of the first isolation layer that is not covered by the first covering layer, the edge of the second film layer shrinks inward relative to the edge of the third film layer and the edge of the first film layer, thereby making the first film layer, the second film layer, and the third film layer of the first isolation layer become the first conductive layer, the second conductive layer, and the third conductive layer of the first isolation portion, respectively.

In some exemplary embodiments, the display substrate illustrated in FIG. 2 and the isolation post illustrated in FIG. 8 are taken as examples, and the first isolation portion 51 and the source electrode 2013 and the drain electrode 2014 of the transistor 201 are disposed in a same layer, and the first covering layer 52 and the passivation layer 251 in the fifth insulation layer 25 are disposed in a same layer. For example, the manufacturing process of the display substrate may include the following operations.

A first insulation layer 21, a semiconductor layer, a second insulation layer 22, a first gate metal layer, a third insulation layer 23, a second gate metal layer, and a fourth insulation layer 24 are sequentially formed on the base substrate 10.

A first post base layer 551 is formed on the third insulation layer 23 of the transition region 300 while forming the fourth insulation layer 24 of the display region 100, that is, the first post base layer 551 and the fourth insulation layer 24 are disposed in a same layer and made of the same material. The fourth insulation layer 24 of the display region 100 is provided with a plurality of first vias V1 exposing one end of the plurality of active layers 2011 and a plurality of second vias V2 exposing the other end of the plurality of active layers 2011. The above content may be understood with reference to FIG. 15a.

Subsequently, a first source-drain metal thin film is deposited, and the first source-drain metal thin film is patterned by a patterning process to form a pattern of a first source-drain metal layer on the fourth insulation layer 24. The pattern of the first source-drain metal layer includes a plurality of source electrodes 2013 and a plurality of drain electrodes 2014 located in the display region 100, and a first isolation layer located on the first post base layer 551 of the transition region 300. A source electrode 2013 is connected to one end of an active layer 2011 through a first via, and a drain electrode 2014 is connected to the other end of the active layer 2011 through a second via, and the plurality of active layers 2011, the plurality of gate electrodes 2012, the plurality of source electrodes 2013, and the plurality of drain electrodes 2014 of the display region 100 form a plurality of transistors 201. The above contents may be understood with reference to FIG. 15b.

The first source-drain metal layer may include a first metal layer 301, a second metal layer 302, and a third metal layer 303 sequentially stacked along a direction away from the base substrate 10. For example, the first metal layer 301 and the third metal layer 303 may be a titanium layer, and the second metal layer 302 may be an aluminum layer. Then, the source electrode 2013, the drain electrode 2014, and the first isolation layer each include a first metal layer 301 (Ti), a second metal layer 302 (Al), and a third metal layer 303 (Ti) which are sequentially stacked along a direction away from the base substrate 10. Edges of the first metal layer 301, the second metal layer 302, and the third metal layer 303 of the first isolation layer may be substantially flush on a side of the first isolation layer facing the display region 100 and a side of the first isolation layer facing the hole region 200. The above contents may be understood with reference to FIG. 15b.

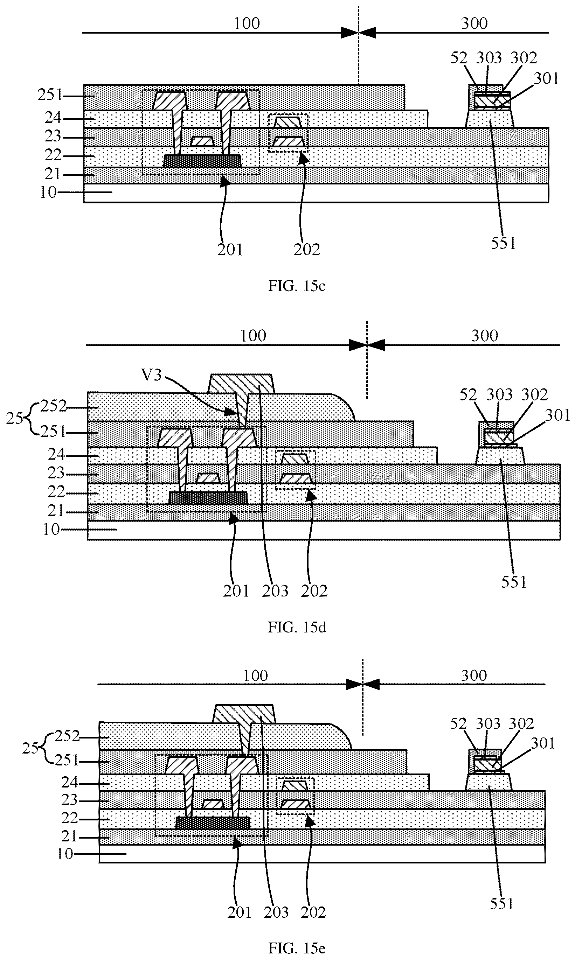

Subsequently, a passivation thin film is deposited, and the passivation thin film is patterned by a patterning process to form a pattern of a passivation layer 251 overlaying the first source-drain metal layer. The pattern of the passivation layer 251 includes a first covering layer 52 located in the transition region 300. The first covering layer 52 is disposed on a surface of the third metal layer 303 of the first isolation layer away from the base substrate 10 and covers a side of the first isolation layer facing the display region 100 or the hole region 200 (the side facing the display region 100 in the example of FIG. 15c). A portion of the third metal layer 303 of the first isolation layer close to a side of the first isolation layer that is not covered by the first covering layer 52 is not overlaid by the first covering layer 52 (that is, an edge of the third metal layer 303 of the first isolation layer protrudes from an edge of the first covering layer 52 on a side of the first isolation layer that is not covered by the first covering layer 52). The above contents may be understood with reference to FIG. 15c.

Subsequently, a first planarization thin film is coated, and the first planarization thin film is patterned by a patterning process to form a pattern of a first planarization layer 252 disposed on the passivation layer 251. The first planarization layer 252 is formed with a plurality of third vias V3 located in the display region 100, the first planarization layer 252 and the passivation layer 251 in the third vias V3 are removed and a surface of the drain electrode 2014 is exposed. The above contents may be understood with reference to FIG. 15d. In this example, an entirety of the passivation layer 251 and the first planarization layer 252 may be referred to as a fifth insulation layer 25, the passivation layer 251 may be made of an inorganic insulation material, and the first planarization layer 252 may be made of an organic insulation material. In other examples, the passivation layer 251 may not be provided, and the fifth insulation layer 25 may include only the first planarization layer 252, in which case, the first covering layer 52 may be formed simultaneously in the patterning process of forming the pattern of the first planarization layer 252.

Subsequently, a second source-drain metal thin film is deposited, and the second source-drain metal thin film is patterned by a patterning process to form a pattern of a second source-drain metal layer on the first planarization layer 252. The pattern of the second source-drain metal layer includes a plurality of anode connection electrodes 203 located in the display region 100, and the anode connection electrodes 203 are connected to the drain electrodes 2014 through the third vias V3. The above contents may be understood with reference to FIG. 15d.

The film layer structure and material of the second source-drain metal layer may be the same as the film layer structure and material of the first source-drain metal layer. For example, the second source-drain metal layer may include a fourth metal layer 401, a fifth metal layer 402, and a sixth metal layer 403 sequentially stacked along a direction away from the base substrate 10. For example, the fourth metal layer 401 and the sixth metal layer 403 may be a titanium layer, and the fifth metal layer 402 may be an aluminum layer. Therefore, during the patterning process of the second source-drain metal thin film, a portion of the first isolation layer of the transition region 300 that is not overlaid by the first covering layer 52 is also etched. After this patterning process is completed, portions of the third metal layer 303 and the second metal layer 302 of the first isolation layer of the transition region 300 that are not overlaid by the first covering layer 52 are etched away. On a side of the first isolation layer that is not covered by the first covering layer 52, edges of the third metal layer 303 and the second metal layer 302 of the first isolation layer are substantially flush with an edge of the first covering layer 52, and an edge of the first metal layer 301 of the first isolation layer protrudes from the edges of the third metal layer 303 and the second metal layer 302. Since the first metal layer 301 made of titanium of the first isolation layer is more difficult to etch than the second metal layer 302 made of aluminum, after the patterning process is completed, on the side of the first isolation layer that is not covered by the first covering layer 52, the edge of the first metal layer 301 of the first isolation layer protrudes from the edge of the second metal layer 302. The above contents may be understood with reference to FIG. 15d.

Subsequently, a portion of the third metal layer 303 of the first isolation layer located in the transition region 300 close to a side of the first isolation layer that is not covered by the first covering layer 52 is etched and removed by an etching process. Then, a portion of the first covering layer 52 close to a side of the first isolation layer that is not covered by the first covering layer 52 will droop without the support of the third metal layer 303, and will cover a surface of the third metal layer 303 located on a side of the first isolation layer that is not covered by the first covering layer 52. The above contents may be understood with reference to FIG. 15e.

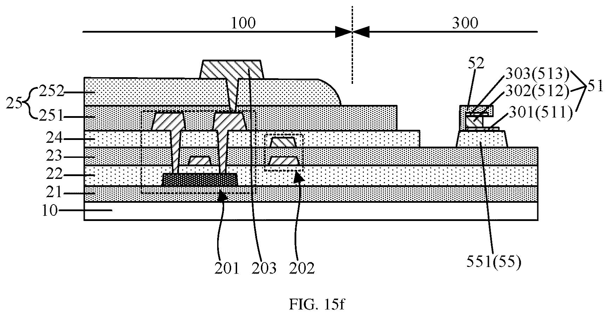

Subsequently, the second metal layer 302 of the first isolation layer of the transition region 300 may be transversely etched using a mask by a wet etching process, so that on a side of the first isolation layer that is not covered by the first covering layer 52, the second metal layer 302 of the first isolation layer shrinks inward relative to the third metal layer 303 and the first metal layer 301. Thus, the final structure of the isolation post 50 is formed, and the first metal layer 301, the second metal layer 302, and the third metal layer 303 of the first isolation layer become the first conductive layer 511, the second conductive layer 512, and the third conductive layer 513 of the first isolation portion 51 of the isolation post 50, and the first post base layer 551 forms the post base 55. The above contents may be understood with reference to FIG. 15f.

Subsequently, the remaining film layers of the display substrate are formed.

Based on the process of FIGS. 15a to 15f, an embodiment of the present disclosure provides a manufacturing method for a display substrate, including manufacturing an isolation post illustrated in FIG. 8. The manufacturing process of the isolation post illustrated in FIG. 8 may include:
forming a first isolation layer on the base substrate of the transition region, wherein the first isolation layer includes a first film layer, a second film layer, and a third film layer sequentially stacked along a direction away from the base substrate, and edges of the first film layer, the second film layer, and the third film layer are flush on a side of the first isolation layer facing the display region and a side of the first isolation layer facing the hole region;
forming a first covering layer on a surface of the third film layer away from the base substrate, wherein the first covering layer covers a side of the first isolation layer facing the display region or the hole region, and on a side of the first isolation layer that is not covered by the first covering layer, edges of the first film layer, the second film layer, and the third film layer protrude from an edge of the first covering layer (i.e., a portion of a surface of the third film layer away from the base substrate, which is close to the side of the first isolation layer that is not covered by the first covering layer, is not overlaid by the first covering layer);
etching the first isolation layer by an etching process, so that on a side of the first isolation layer that is not covered by the first covering layer, the edges of the second film layer and the third film layer are flush with the edge of the first covering layer, and the edge of the first film layer protrudes from the edges of the second film layer and the third film layer;
etching the third film layer by an etching process, so that on a side of the first isolation layer that is not covered by the first covering layer, the edge of the third film layer shrinks inward relative to the edge of the first covering layer, and then a portion of the first covering layer that is not supported by the third film layer droops, and covers a surface of the third film layer located on a side of the first isolation layer that is not covered by the first covering layer; and
etching the second film layer by an etching process so that on the side of the first isolation layer that is not covered by the first covering layer, the edge of the second film layer shrinks inward relative to the edge of the third film layer and the edge of the first film layer, thereby making the first film layer, the second film layer, and the third film layer of the first isolation layer become the first conductive layer, the second conductive layer, and the third conductive layer of the first isolation portion, respectively.

An embodiment of the present disclosure further provides a display apparatus, which includes the display substrate according to any one of the previous embodiments. The display apparatus may be any product or component with a display function, such as a mobile phone, a tablet computer, a television, a display, a laptop computer, a digital photo frame, and a navigator.

In the accompanying drawings, a size of a constituent element, and a thickness of a layer or a region are sometimes exaggerated for clarity. Therefore, an implementation of the present disclosure is not necessarily limited to the size, and the shape and size of each component in the drawings do not reflect an actual scale. In addition, the drawings schematically illustrate some examples, and an implementation of the present disclosure is not limited to the shapes or numerical values shown in the drawings.

In the description herein, "parallel" refers to a state in which an angle formed by two straight lines is above -10° and below 10°, and thus includes a state in which the angle is above -5° and below 5°. In addition, "perpendicular" refers to a state in which an angle formed by two straight lines is above 80° and below 100°, and thus includes a state in which the angle is above 85° and below 95°.

In the description herein, orientation or position relationships indicated by the terms "upper", "lower", "left", "right", "top", "inside", "outside", "axial", "four corners" and the like are orientation or position relationships shown in the drawings, and are intended to facilitate description of the embodiments of the present disclosure and simplification of the description, but not to indicate or imply that the mentioned structure has a specific orientation or is constructed and operated in a specific orientation, therefore, they should not be understood as limitations on the present disclosure.

In the description herein, unless otherwise specified and defined explicitly, terms "connection", "fixed connection", "installation", and "assembly" should be understood in a broad sense. For example, it may be a fixed connection, a detachable connection, or an integrated connection; terms "installation", "connection", and "fixed connection" may be a direct connection, an indirect connection through an intermediary, or communication inside two elements. For those ordinarily skilled in the art, meanings of the above terms in the embodiments of the present disclosure may be understood according to situations.

## Claims

1. A display substrate comprising a hole region, a transition region around the hole region, and a display region around the transition region; wherein the transition region is provided with an isolation post around the hole region, and the isolation post comprises a first isolation portion and a first covering layer;
the display substrate comprises a base substrate, the first isolation portion comprises a second conductive layer, a first side of the first isolation portion faces the display region, and a second side of the first isolation portion faces the hole region; and
the first covering layer is disposed on a side of the first isolation portion away from the base substrate, and covers one of the first side and the second side of the first isolation portion, and on the other of the first side and the second side of the first isolation portion, the second conductive layer shrinks inward relative to the first covering layer; and a material of the first covering layer is an insulation material.

2. The display substrate according to claim 1, wherein the first isolation portion further comprises a first conductive layer disposed on a side of the second conductive layer close to the base substrate, the first covering layer is disposed on a surface of the second conductive layer away from the base substrate, and covers one of the first side and the second side of the first isolation portion, and the second conductive layer also shrinks inward relative to the first conductive layer on the other of the first side and the second side of the first isolation portion.

3. The display substrate according to claim 1, wherein the first isolation portion further comprises a third conductive layer disposed on a side of the second conductive layer away from the base substrate, and the first covering layer is disposed on a surface of the third conductive layer away from the base substrate, and covers one of the first side and the second side of the first isolation portion; and the second conductive layer also shrinks inward relative to the third conductive layer on the other of the first side and the second side of the first isolation portion.

4. The display substrate according to claim 3, wherein the first covering layer further covers a surface of the third conductive layer located on the other of the first side and the second side of the first isolation portion, and an orthographic projection of the third conductive layer on the base substrate falls within an orthographic projection of the first covering layer on the base substrate.

5. The display substrate according to any one of claims 1 to 4, wherein the second conductive layer shrinks inward by 0.35 microns to 0.4 microns relative to the first covering layer.

6. The display substrate according to claim 5, wherein a portion of the first covering layer close to an edge thereof has a slope angle of 20 degrees to 45 degrees on the other of the first side and the second side of the first isolation portion.

7. The display substrate according to claim 1, wherein the isolation post further comprises a second isolation portion disposed on a side of the first isolation portion facing the base substrate, and the second isolation portion comprises a fourth conductive layer and a fifth conductive layer sequentially stacked along a direction away from the base substrate; a first side of the second isolation portion faces the display region and a second side of the second isolation portion faces the hole region; the first covering layer also covers one of the first side and the second side of the second isolation portion, and the fifth conductive layer shrinks inward relative to the fourth conductive layer on the other of the first side and the second side of the second isolation portion.

8. The display substrate according to claim 7, wherein the second isolation portion further comprises a sixth conductive layer disposed on a side of the fifth conductive layer away from the base substrate, and the fifth conductive layer also shrinks inward relative to the sixth conductive layer on the other of the first side and the second side of the second isolation portion.

9. The display substrate according to claim 1, wherein the isolation post further comprises a second isolation portion and a second covering layer; the second isolation portion is disposed on a side of the first isolation portion facing the base substrate, a first side of the second isolation portion faces the display region, and a second side of the second isolation portion faces the hole region; the second covering layer is disposed between the second isolation portion and the first isolation portion, and covers one of the first side and the second side of the second isolation portion; a material of the second isolation portion is a conductive material, and a material of the second covering layer is an insulation material.

10. The display substrate according to claim 9, wherein the second isolation portion comprises a fourth conductive layer, a fifth conductive layer, and a sixth conductive layer stacked sequentially along a direction away from the base substrate; and the fifth conductive layer shrinks inward relative to the fourth conductive layer and the sixth conductive layer on the other of the first side and the second side of the second isolation portion.

11. The display substrate according to claim 9, wherein one of the first side and the second side of the first isolation portion covered by the first covering layer is located on a different side of the isolation post than one of the first side and the second side of the second isolation portion covered by the second covering layer.

12. The display substrate according to any one of claims 1 to 4, wherein the isolation post further comprises a post base disposed on a side of the first isolation portion facing the base substrate, and the post base comprises one or more film layers.

13. The display substrate according to claim 12, wherein the post base comprises one inorganic insulation layer or a plurality of inorganic insulation layers that are stacked; or, the post base comprises at least one inorganic insulation layer and at least one metal layer, and the metal layer is covered by the inorganic insulation layer.

14. The display substrate according to claim 1, wherein the display region comprises a drive structure layer and a light emitting structure layer sequentially stacked on the base substrate, the drive structure layer comprises a pixel drive circuit, the pixel drive circuit comprises a plurality of transistors and a storage capacitor, the light emitting structure layer comprises a plurality of light emitting elements, and each light emitting element comprises a first electrode, a light emitting functional layer, and a second electrode layer sequentially stacked along a direction away from the base substrate; and
in a direction perpendicular to the base substrate, the drive structure layer comprises a first source-drain metal layer, a fifth insulation layer, a second source-drain metal layer, and a second planarization layer sequentially disposed along the direction away from the base substrate; the first source-drain metal layer comprises a source electrode and a drain electrode of at least one of the transistors, and the second source-drain metal layer comprises a connection electrode connected to the source electrode or the drain electrode of the transistor, and the connection electrode is also connected to the first electrode.

15. The display substrate according to claim 14, wherein the first source-drain metal layer comprises a plurality of metal layers that are stacked, the first isolation portion and the source electrode and the drain electrode of the transistor are disposed in a same layer, and the first covering layer and the fifth insulation layer are disposed in a same layer.

16. The display substrate according to claim 14, wherein the second source-drain metal layer comprises a plurality of metal layers that are stacked, the first isolation portion and the connection electrode are disposed in a same layer, and the first covering layer and the second planarization layer are disposed in a same layer.

17. The display substrate according to claim 14, wherein the isolation post further comprises a second isolation portion disposed on a side of the first isolation portion facing the base substrate, and the second isolation portion comprises a fourth conductive layer and a fifth conductive layer sequentially stacked along the direction away from the base substrate; a first side of the second isolation portion faces the display region and a second side of the second isolation portion faces the hole region; the first covering layer also covers one of the first side and the second side of the second isolation portion, and the fifth conductive layer shrinks inward relative to the fourth conductive layer on the other of the first side and the second side of the second isolation portion; and
the first source-drain metal layer and the second source-drain metal layer each comprise a plurality of metal layers that are stacked, the first isolation portion and the connection electrode are disposed in a same layer, the first covering layer and the second planarization layer are disposed in a same layer, and the second isolation portion and the source electrode and the drain electrode of the transistor are disposed in a same layer.

18. The display substrate according to claim 14, wherein the isolation post further comprises a second isolation portion and a second covering layer; the second isolation portion is disposed on a side of the first isolation portion facing the base substrate, a first side of the second isolation portion faces the display region, and a second side of the second isolation portion faces the hole region; the second covering layer is disposed between the second isolation portion and the first isolation portion, and covers one of the first side and the second side of the second isolation portion; a material of the second isolation portion is a conductive material, and a material of the second covering layer is an insulation material; and
the first source-drain metal layer and the second source-drain metal layer each comprise a plurality of metal layers that are stacked, the first isolation portion and the connection electrode are disposed in a same layer, the first covering layer and the second planarization layer are disposed in a same layer, the second isolation portion and the source electrode and the drain electrode of the transistor are disposed in a same layer, and the second covering layer and the fifth insulation layer are disposed in a same layer.

19. The display substrate according to claim 14, wherein the drive structure layer further comprises a semiconductor layer, a first gate metal layer and a second gate metal layer which are disposed on a side of the first source-drain metal layer facing the base substrate, the semiconductor layer comprises an active layer of the transistor, the first gate metal layer comprises a gate electrode of the transistor and one plate of the storage capacitor, and the second gate metal layer comprises the other plate of the storage capacitor; and
the isolation post further comprises a post base disposed on a side of the first isolation portion facing the base substrate, the post base comprises at least one inorganic insulation layer and at least one metal layer, the metal layer is covered by the inorganic insulation layer, and the metal layer and the first gate metal layer or the second gate metal layer are disposed in a same layer.

20. The display substrate according to claim 14, wherein the fifth insulation layer comprises a passivation layer and a first planarization layer stacked sequentially along the direction away from the base substrate, the passivation layer is an inorganic insulation layer and the first planarization layer is an organic insulation layer; or, the fifth insulation layer comprises only a first planarization layer, and the first planarization layer is an organic insulation layer.

21. A display apparatus, comprising the display substrate according to any one of claims 1 to 20.

22. A manufacturing method for the display substrate of claim 2, comprising:
forming a first isolation layer on the base substrate of the transition region, wherein the first isolation layer comprises a first film layer, a second film layer, and a third film layer sequentially stacked along a direction away from the base substrate, and edges of the first film layer, the second film layer, and the third film layer are flush on a side of the first isolation layer facing the display region and a side of the first isolation layer facing the hole region;
completely removing the third film layer by an etching process;
forming a first covering layer on a surface of the second film layer away from the base substrate, wherein the first covering layer covers the side of the first isolation layer facing the display region or the hole region, and on a side of the first isolation layer that is not covered by the first covering layer, edges of the second film layer and the first film layer protrude from an edge of the first covering layer;
etching the first isolation layer by the etching process so that on the side of the first isolation layer that is not covered by the first covering layer, the edge of the second film layer is flush with the edge of the first covering layer, and the edge of the first film layer protrudes from the edge of the second film layer or is flush with the edge of the second film layer; and
etching the second film layer by the etching process so that on the side of the first isolation layer that is not covered by the first covering layer, the edge of the second film layer shrinks inward relative to the edge of the first covering layer and the edge of the first film layer, thereby making the first film layer and the second film layer of the first isolation layer become the first conductive layer and the second conductive layer of the first isolation portion, respectively.
